# EUROPEAN PATENT APPLICATION

(11) **EP 4 571 837 A1**
(43) Date of publication of application: **18.06.2025**
(21) Application number: 22959614.3
(22) Date of filing: 23.09.2022
(51) Int. Cl.: H01L 27/15, H01L 25/075, H01L 27/12, H01L 33/62, H01L 33/60

(54) **DISPLAY DEVICE**

(71) Applicant: LG Electronics Inc., Yeongdeungpo-gu Seoul 07336 (KR); LG Display Co., Ltd., Seoul, 07336 (KR)
(72) Inventor: LEE, Hongcheol, Seoul 06772 (KR); KIM, Youngdo, Seoul 06772 (KR); LEE, Kyungdong, Seoul 06772 (KR)
(74) Representative: Vossius & Partner Patentanwälte Rechtsanwälte mbB
(86) International application number: PCT/KR2022/014240
(87) International publication number: WO 2024/063181

(57) **Abstract**

The display device may include a substrate, a first assembly wiring and a second assembly wiring on the substrate, an insulating layer having a recess on the first assembly wiring and the second assembly wiring, a partition wall disposed on the first assembly wiring and the second assembly wiring and having an assembly hole that is in contact with the recess, a semiconductor light-emitting element in the assembly hole, a fixing member in the recess, and a connection electrode between an outer side of the semiconductor light-emitting element and an inner side of the assembly hole. The fixing member and the connection electrode may include an aggregate of lumps in which a plurality of conductive nanoparticles are entangled with each other.

## Description

### [Technical Field]

The embodiment relates to a display device.

### [Background Art]

A large-area display includes a liquid crystal display (LCD), an OLED display, and a micro-LED display.

A micro-LED display is a display that uses the micro-LEDs, which are semiconductor light-emitting elements with a diameter or cross-sectional area of 100µm or less, as display elements.

Since the micro-LED display uses the micro-LEDs, which are semiconductor light-emitting elements, as display elements, it has excellent performance in many characteristics such as contrast ratio, response speed, color reproducibility, viewing angle, brightness, resolution, lifespan, luminescence efficiency, and luminance.

In particular, a micro-LED display has the advantage of being able to freely adjust the size or resolution and implement a flexible display because the screen may be separated and combined in a modular manner.

However, since a large-area micro-LED display requires millions or more micro-LEDs, there is a technical problem that it is difficult to quickly and accurately transfer the micro-LEDs to a display panel.

Recently developed transfer technologies include pick and place process, laser lift-off method, or self-assembly method.

Among these, self-assembly method is advantageous for implementing a large-screen display device as it is a method in which semiconductor light-emitting elements find their assembly positions in a fluid.

However, research on the technology for manufacturing displays through self-assembly of the micro-LEDs is still insufficient.

In particular, in a conventional technology, when transferring millions or more semiconductor light-emitting elements to a large display quickly, the transfer speed can be improved, but there is a technical problem that the transfer error rate can increase and the transfer yield can be lowered.

In the related technology, a self-assembly transfer process using dielectrophoresis (DEP) is being attempted, but there is a problem in that the self-assembly rate is low due to the unevenness of the DEP force.

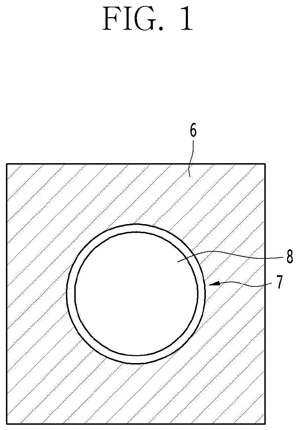

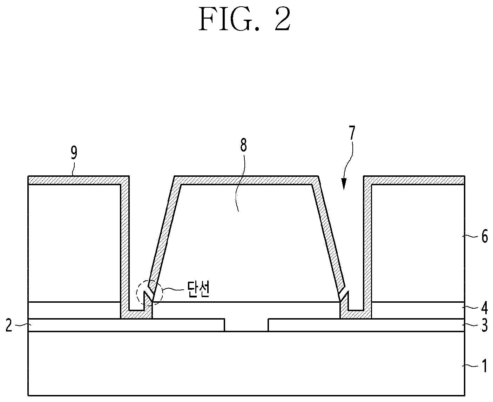

Meanwhile, as illustrated in FIGS. 1 and 2, an assembly hole 7 is formed on a substrate 1 for self-assembly, and a semiconductor light-emitting element 8 is assembled into the assembly hole 7. Thereafter, a metal film 9 is deposited on the substrate 1 using a deposition process to form a lateral electrode.

However, since the gap between the outer side of the semiconductor light-emitting element 8 and the inner side of the assembly hole 7 is very narrow, it is difficult for the metal material to be transferred to a first assembly wiring 2 and a second assembly wiring 3 through the gap, and even if the metal material is transferred to the first assembly wiring 2 and the second assembly wiring 3, there is a limit to depositing a thick film thickness, so that there is a problem that an electrical disconnection occurs or the film quality deteriorates. This problem is likely to be carried over to a post-process, and there is a problem that it causes a lighting defect when implementing a display device.

Unexplained reference numeral 6 is a partition wall, which is provided to form the assembly hole 7. The unexplained reference numeral 4 is an insulating layer, which protects the first assembly wiring 2 and the second assembly wiring 3.

According to the non-public internal technology, as illustrated in FIG. 2, after the semiconductor light-emitting element 8 is assembled in the assembly hole 7, the metal film 9 is not formed, but the partition wall 6 may be removed. Since the partition wall 6 is removed, there is no physical obstruction in the lateral direction of the semiconductor light-emitting element 8. Accordingly, the metal film 9 is deposited on the substrate 1 as well as the semiconductor light-emitting element 8 without any physical obstruction in the lateral direction of the semiconductor light-emitting element 8, and the metal film 9 is patterned so that the lateral part of the semiconductor light-emitting element 8 and the first assembly wiring 2 may be electrically connected.

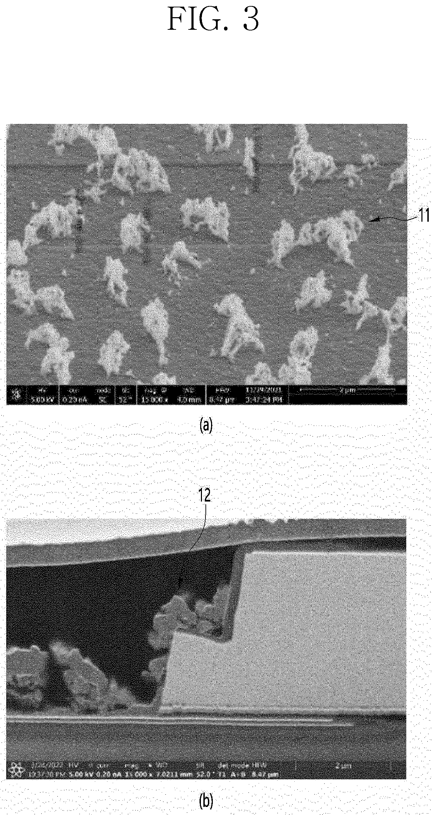

However, when the partition wall 6 is removed using an ashing process, as illustrated in FIG. 3(a), an oxidized organic residual film 11 is formed on the substrate 1 corresponding to a region where the partition wall 6 was. That is, the partition wall 6 is removed by dry etching using O2 plasma as an ashing process. In this instance, rather than removing oxygen (O2) and the partition wall 6, the partition wall 6 is oxidized to form the oxidized organic residue film 11 on the surface of the substrate 1.

As illustrated in FIG. 3(b), when the metal film is deposited and patterned to form the lateral electrode 12 while the oxidized organic residue film 11 is formed, there is a problem that the lateral electrode 12 is disconnected or the roughness of the lateral electrode 12 increases due to the oxidized organic residue film 11, resulting in an increase in electrical resistance.

In addition, since the thickness of the partition wall 6 is thick, it takes a long time to completely remove the partition wall 6 by the ashing process, which increases the process time.

Meanwhile, as illustrated in FIGS. 1 and 2, since a process of fixing the semiconductor light-emitting element 8 to the insulating layer 4 must be added so that the semiconductor light-emitting element 8 does not fall out of the assembly hole 7 while the metal film 9 is formed after the semiconductor light-emitting element 8 is assembled or the metal film 9 is formed after the partition 6 is removed, there is a problem that the process time becomes long and complicated.

### [Disclosure]

### [Technical Problem]

An object of the embodiment is to solve the foregoing and other problems.

Another object of the embodiment is to provide a display device in which fixation and electrical connection of a semiconductor light-emitting element are implemented simultaneously.

In addition, another object of the embodiment is to provide a display device in which a connection electrode (lateral electrode) may be easily formed without a disconnection.

In addition, another object of the embodiment is to provide a display device in which the fixation of the semiconductor light-emitting element may be strengthened.

In addition, another object of the embodiment is to provide a display device in which heat dissipation characteristics can be improved.

In addition, another object of the embodiment is to provide a display device capable of improving light luminance.

In addition, another object of the embodiment is to provide a display device capable of implementing high resolution or ultra-high resolution.

In addition, another object of the embodiment is to provide a display device capable of drastically reducing the process time without the need to remove the partition wall.

The technical problems of the embodiments are not limited to those described in this item and include those that may be understood through the description of the invention.

### [Technical Solution]

In order to achieve the above or other objects, according to one aspect of the embodiment, a display device, comprising: a substrate; a first assembly wiring and a second assembly wiring on the substrate; an insulating layer having a recess on the first assembly wiring and the second assembly wiring; a partition wall disposed on the first assembly wiring and the second assembly wiring and having an assembly hole that is in contact with the recess; a semiconductor light-emitting element in the assembly hole; a fixing member in the recess; and a connection electrode between an outer side of the semiconductor light-emitting element and an inner side of the assembly hole, wherein the fixing member and the connection electrode comprise an aggregate of lumps in which a plurality of conductive nanoparticles are entangled with each other.

The plurality of conductive nanoparticles may comprise at least one or more particle of electrode particles, magnetization particles, and reflection particles.

A density of the magnetization particle may increase as it moves away from an upper surface of the connection electrode in a downward direction.

Adjacent electrode particles may be entangled with each other through the magnetization particles.

A part of the connection electrode may extend between the semiconductor light-emitting element and the insulating layer.

An upper surface of the connection electrode has a non-uniform surface.

An upper surface of the connection electrode has a round surface.

The display device may comprise a second insulating layer on the partition wall, the semiconductor light-emitting element, and the connection electrode; and an electrode wiring on the second insulating layer. The connection electrode may connect a lateral part of the semiconductor light-emitting element to at least one or more of the first assembly wiring or the second assembly wiring, and the electrode wiring may be connected to an upper part of the semiconductor light-emitting element.

The display device may comprise a third insulating layer between the connection electrode and the second insulating layer in the assembly hole.

The connection electrode may comprise a plurality of blocks, and a material of the blocks may be the same as a material of the third insulating layer.

The connection electrode may comprise a plurality of bars, and a material of the bars may be the same as a material of the third insulating layer.

Some of the plurality of bars may be connected to the third insulating layer.

The connection electrode may comprise a plurality of pores, and the pore may comprise air.

The fixing member may be disposed between the first assembly wiring and the second assembly wiring and between a lower surface of the semiconductor light-emitting element and an upper surface of the insulating layer.

The fixing member may be connected to the connection electrode.

The connection electrode and the fixing member may comprise reflective layers.

The connection electrode may be disposed along a perimeter of the semiconductor light-emitting element in the assembly hole.

A gap between the outer side of the semiconductor light-emitting element and the inner side of the assembly hole may be 1.5 micrometers or less.

### [Advantageous Effects]

In an embodiment, fixation and electrical connection of a semiconductor light-emitting device can be implemented simultaneously using a solution coating and melting process.

In particular, since the connection electrode (lateral electrode) is formed using a solution coating and melting process, even if the gap between the outer side of the semiconductor light-emitting element and the inner side of the assembly hole is narrow, a disconnection does not occur in the connection electrode, thereby preventing poor lighting. Accordingly, the gap may be further narrowed, so that high resolution or ultra-high resolution can be implemented.

In addition, since the formation of a connection electrode without a disconnection is possible without removing the partition wall, an increase in process time due to the removal of the partition wall may be prevented.

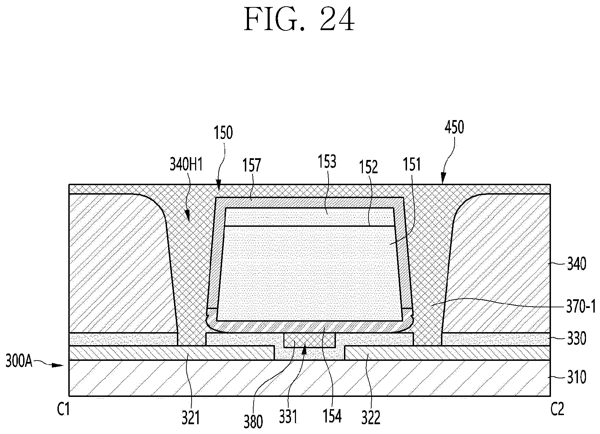

As illustrated in FIG. 24, since a fixing member 380 is formed simultaneously with a connection electrode 370-1, there is no need to form a separate fixing member, so that the process is simple and the process time can be shortened.

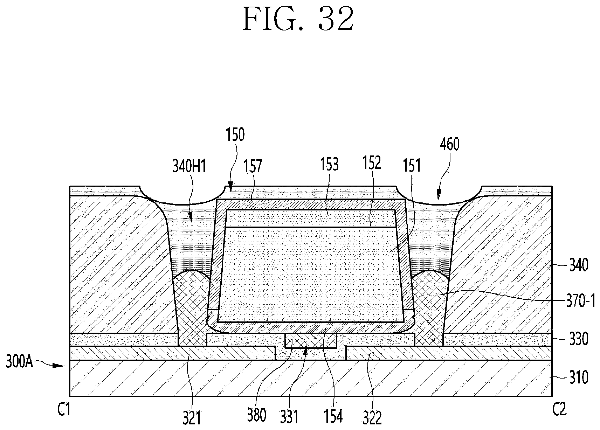

As illustrated in FIG. 32, not only the connection electrode 370-1 and the fixed member 380, but also a third insulating layer 390 may be formed using the solution coating and melting process. Accordingly, the semiconductor light-emitting element 150-1 may be fixed to the substrate 310 not only by the fixed member 380 but also by the third insulating layer 390, so that the fixation of the semiconductor light-emitting element 150-1 can be strengthened.

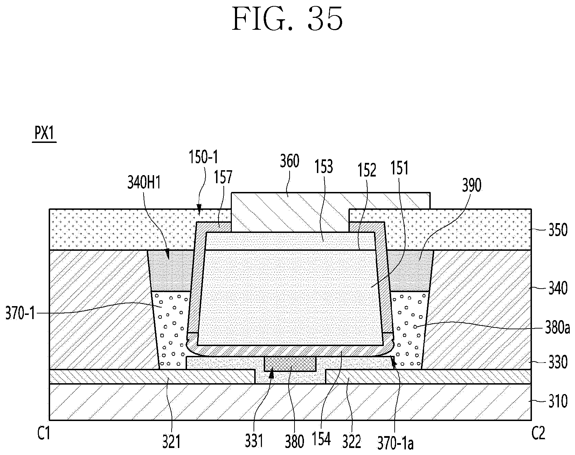

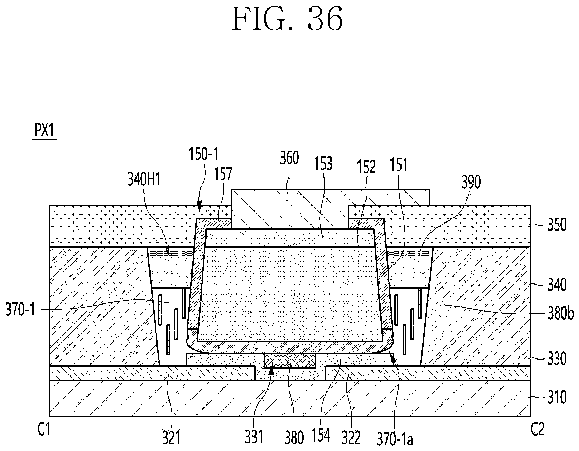

By performing the melting process, a part of the third insulating layer 390 may be formed into a plurality of blocks (380a of FIG. 35) or a plurality of bars (380b of FIG. 36) in the connection electrode 370-1. Since the plurality of blocks 380a or plurality of bars 380b release heat generated from the semiconductor light-emitting element 150-1 through the connection electrode 370-1, heat dissipation characteristics can be improved. The blocks may be called dots or patterns.

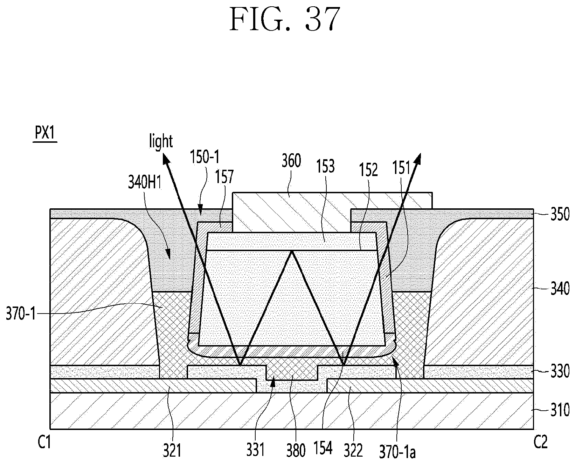

As illustrated in FIG. 37, the connection electrode 370-1 and the fixing member 380 may be disposed on a lateral part and a lower side of the semiconductor light-emitting element 150-1, and the reflective particles 403 may be distributed on each of the connection electrode 370-1 and the fixing member 380 so as to be used as a reflective layer. Accordingly, the light generated from the semiconductor light-emitting element 150-1 may be reflected forward, so that light efficiency and luminance can be improved.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a plan view illustrating a semiconductor light-emitting element assembled in an assembly hole using an assembly method.
FIG. 2 is a cross-sectional view illustrating occurrence of a disconnection during metal deposition.
FIG. 3(a) is a plan view showing an oxidized organic residue film that occurs when a partition wall is removed.
FIG. 3(b) is a cross-sectional view showing a defect in a lateral electrode caused by the oxidized organic residue film of FIG. 3(a).
FIG. 4 illustrates a living room of a house in which a display device according to an embodiment is disposed.
FIG. 5 is a block diagram schematically showing a display device according to an embodiment.
FIG. 6 is a circuit diagram showing an example of a pixel of FIG. 5.
FIG. 7 is an enlarged view of a first panel region in the display device of FIG. 4.
FIG. 8 is an enlarged view of a region A2 of FIG. 7.
FIG. 9 is a drawing illustrating an example of a light-emitting element according to an embodiment being assembled on a substrate by a self-assembly method.
FIG. 10 is a plan view illustrating a display device according to an embodiment.
FIG. 11 is a cross-sectional view illustrating a first subpixel according to a first embodiment.
FIG. 12 illustrates a lump that constitutes a connection electrode and a fixing member.
FIG. 13 illustrates an aggregate in which the lumps of FIG. 12 are combined.
FIG. 14 illustrates the density of magnetizing particles in a connection electrode.
FIG. 15 illustrates a state in which adjacent electrode particles are entangled with each other by means of magnetizing particles.
FIG. 16 is an example of an upper surface of a connection electrode.
FIG. 17 is another example of an upper surface of a connection electrode.
FIG. 18 illustrates a display device manufactured using a backplane substrate.
FIGS. 19 to 26 illustrate a manufacturing process of a first subpixel according to the first embodiment.
FIG. 27 is a cross-sectional view illustrating a first subpixel according to a second embodiment.
FIGS. 28 to 34 illustrate a manufacturing process of a first subpixel according to the second embodiment.
FIG. 35 is a cross-sectional view illustrating a first subpixel according to a third embodiment.
FIG. 36 is a cross-sectional view illustrating a first subpixel according to a fourth embodiment.
FIG. 37 is a cross-sectional view illustrating a first subpixel according to a fifth embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile terminal such as a mobile phone or smart phone, a computer display such as a laptop or desktop, a head-up display (HUD) for an automobile, a backlight unit for a display, a display for VR, AR or mixed reality (MR), a light source, etc. However, the configuration according to the embodiment described in this specification may be equally applied to a device capable of displaying, even if it is a new product type developed in the future.

The following describes a display device according to the embodiment.

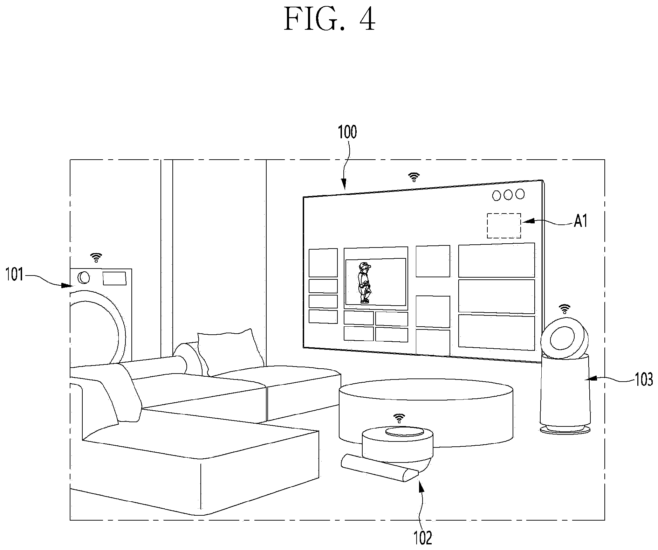

FIG. 4 illustrates a living room of a house in which a display device according to the embodiment is disposed.

Referring to FIG. 4, the display device 100 according to the embodiment may display the status of various electronic products such as a washing machine 101, a robot vacuum cleaner 102, an air purifier 103, etc., and may communicate with each electronic product based on IoT and control each electronic product based on the user's setting data.

The display device 100 according to the embodiment may comprise a flexible display manufactured on a thin and flexible substrate. The flexible display may be bent or rolled like paper while maintaining the characteristics of an existing flat display.

In a flexible display, visual information may be implemented by independently controlling the light emission of unit pixels disposed in a matrix form. A unit pixel means a minimum unit for implementing one color. The unit pixel of the flexible display may be implemented by a light-emitting element. In an embodiment, the light-emitting element may be a micro-LED or a nano-LED, but is not limited thereto.

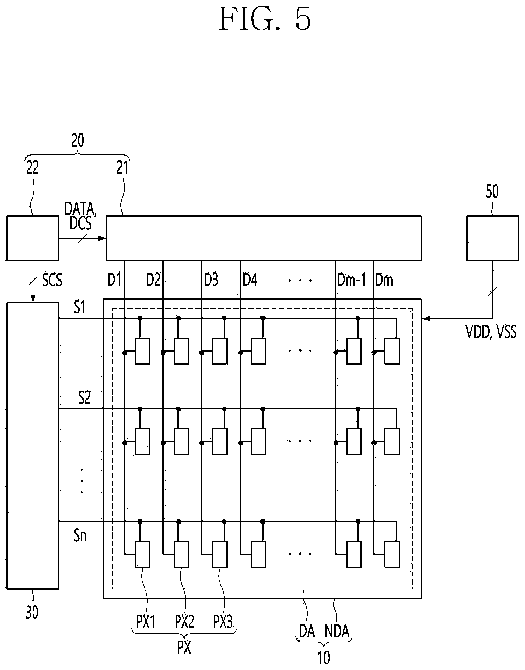

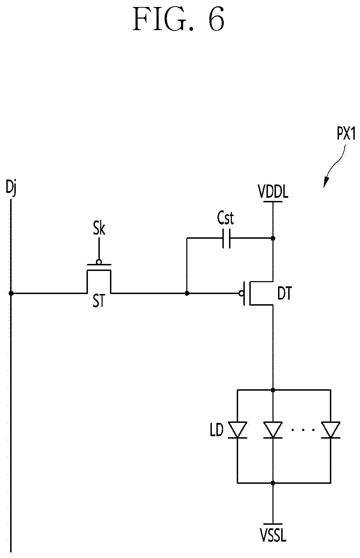

FIG. 5 is a block diagram schematically showing a display device according to an embodiment. FIG. 6 is a circuit diagram showing an example of a pixel of FIG. 5.

Referring to FIG. 5 and FIG. 6, the display device according to an embodiment may comprise a display panel 10, a driving circuit 20, a scan driving unit 30, and a power supply circuit 50.

The display device 100 of the embodiment may drive a light-emitting element in an active matrix (AM) manner or a passive matrix (PM) manner.

The driving circuit 20 may comprise a data driving unit 21 and a timing control unit 22.

The display panel 10 may be formed in a rectangular shape, but is not limited thereto. That is, the display panel 10 may be formed in a circular or oval shape. At least one side of the display panel 10 may be formed to be bent at a predetermined curvature.

The display panel may comprise a display region DA. The display region DA is a region where pixels PX are formed to display an image. The display panel may comprise a non-display region NDA. The non-display region NDA may be a region excluding the display region DA.

As an example, the display region DA and the non-display region NDA may be defined on the same surface. For example, the non-display region NDA may surround the display region DA on the same surface together with the display region DA, but is not limited thereto.

As another example, although not illustrated in the drawing, the display region DA and the non-display region NDA may be defined on different surfaces. For example, the display region DA may be defined on an upper surface of the substrate, and the non-display region NDA may be defined on a lower surface of the substrate. For example, the non-display region NDA may be defined on an entire region or a part of the lower surface of the substrate.

Meanwhile, although the drawing illustrates that the display region DA and the non-display region NDA are divided, the display region DA and the non-display region NDA may not be divided. That is, only the display region DA may exist on the upper surface of the substrate, and the non-display region NDA may not exist. In other words, the entire region of the upper surface of the substrate may be the display region DA where the image is displayed, and the bezel area, which is the non-display region NDA, may not exist.

The display panel 10 may comprise data lines (D1 to Dm, m is an integer greater than or equal to 2), scan lines (S1 to Sn, n is an integer greater than or equal to 2) intersecting the data lines D1 to Dm, a high-potential voltage line VDDL supplied with a high-potential voltage VDD, a low-potential voltage line VSSL supplied with a low-potential voltage VSS, and pixels PX connected to the data lines D1 to Dm and the scan lines S1 to Sn.

Each of the pixels PX may comprise a first subpixel PX1, a second subpixel PX2, and a third subpixel PX3. The first subpixel PX1 may emit a first color light of a first dominant wavelength, the second subpixel PX2 may emit a second color light of a second dominant wavelength, and the third subpixel PX3 may emit a third color light of a third dominant wavelength. The first color light may be red light, the second color light may be green light, and the third color light may be blue light, but is not limited thereto. In addition, although FIG. 5 illustrates that each of the pixels PX comprises three subpixels, the present invention is not limited thereto. That is, each of the pixels PX may comprise four or more subpixels.

Each of the first subpixel PX1, the second subpixel PX2, and the third subpixel PX3 may be connected to at least one of the data lines D1 to Dm, at least one of the scan lines S1 to Sn, and a high-potential voltage line VDDL. The first subpixel PX1 may comprise light-emitting elements LD, a plurality of transistors for supplying current to the light-emitting elements LD, and at least one capacitor Cst, as illustrated in FIG. 6.

Although not illustrated in the drawing, each of the first subpixel PX1, the second subpixel PX2, and the third subpixel PX3 may comprise only one light-emitting element LD and at least one capacitor Cst.

Each of the light-emitting elements LD may be a semiconductor light-emitting diode comprising a first electrode, a plurality of conductivity type semiconductor layers, and a second electrode. Here, the first electrode may be an anode electrode, and the second electrode may be a cathode electrode, but is not limited thereto.

The light-emitting element LD may be one of a lateral-type light-emitting element, a flipchip type light-emitting element, and a vertical-type light-emitting element.

The plurality of transistors may comprise a driving transistor DT for supplying current to the light-emitting elements LD, and a scan transistor ST for supplying a data voltage to a gate electrode of the driving transistor DT, as illustrated in FIG. 6. The driving transistor DT may comprise a gate electrode connected to a source electrode of the scan transistor ST, a source electrode connected to the high-potential voltage line VDDL to which the high-potential voltage VDD is applied, and a drain electrode connected to the first electrodes of the light-emitting elements LD. The scan transistor ST may comprise a gate electrode connected to the scan line (Sk, where k is an integer satisfying 1 ≤ k ≤ n), a source electrode connected to the gate electrode of the driving transistor DT, and a drain electrode connected to the data line (Dj, where j is an integer satisfying 1 ≤ j ≤ m).

A capacitor Cst is formed between the gate electrode and the source electrode of the driving transistor DT. The storage capacitor Cst charges the difference between the gate voltage and the source voltage of the driving transistor DT.

The driving transistor DT and the scan transistor ST may be formed as a thin film transistor. In addition, in FIG. 6, the driving transistor DT and the scan transistor ST are each described mainly as being formed as a P-type metal oxide semiconductor field effect transistor (MOSFET), but the present invention is not limited thereto. The driving transistor DT and the scan transistor ST may be each formed as a N-type MOSFET. In this instance, the positions of the source electrode and the drain electrode of each of the driving transistor DT and the scan transistor ST may be changed.

In addition, in FIG. 6, it is exemplified that each of the first subpixel PX1, the second subpixel PX2, and the third subpixel PX3 comprises 2T1C (2 Transistor - 1 capacitor) having one driving transistor DT, one scan transistor ST, and one capacitor Cst, but the present invention is not limited thereto. Each of the first subpixel PX1, the second subpixel PX2, and the third subpixel PX3 may comprise a plurality of scan transistors STs and a plurality of capacitors Cst.

Since the second subpixel PX2 and the third subpixel PX3 may be expressed by substantially the same circuit diagram as the first subpixel PX1, a detailed description thereof will be omitted.

The driving circuit 20 outputs signals and voltages for driving the display panel 10. To this end, the driving circuit 20 may comprise a data driving unit 21 and a timing control unit 22.

The data driving unit 21 receives digital video data and a source control signal DCS from the timing control unit 22. The data driving unit 21 converts digital video data DATA into analog data voltages according to the source control signal DCS and supplies the converted data to data lines D1 to Dm of the display panel 10.

The timing control unit 22 receives digital video data DATA and timing signals from a host system. The host system may be an application processor of a smartphone or tablet PC, a monitor, a system on chip of a TV, etc.

The timing control unit 22 generates control signals for controlling the operation timing of the data driving unit 21 and the scan driving unit 30. The control signals may comprise a source control signal DCS for controlling the operation timing of the data driving unit 21 and a scan control signal SCS for controlling the operation timing of the scan driving unit 30.

The driving circuit 20 may be disposed in a non-display region NDA provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but the present invention is not limited thereto. For example, the driving circuit 20 may be mounted on a circuit board (not illustrated) other than the display panel 10.

The data driving unit 21 may be mounted on the display panel 10 using a chip on glass (COG) method, a chip on plastic (COP) method, or an ultrasonic bonding method, and the timing control unit 22 may be mounted on the circuit board.

The scan driving unit 30 receives a scan control signal SCS from the timing control unit 22. The scan driving unit 30 generates scan signals according to the scan control signal SCS and supplies them to scan lines S1 to Sn of the display panel 10. The scan driving unit 30 may be formed in the non-display region NDA of the display panel 10 comprising a plurality of transistors. Alternatively, the scan driving unit 30 may be formed as an integrated circuit, in which case it may be mounted on a gate flexible film attached to another side of the display panel 10.

The power supply circuit 50 may generate voltages required for driving the display panel 10 from the main power applied from the system board and supply them to the display panel 10. For example, the power supply circuit 50 may generate a high-potential voltage VDD and a low-potential voltage VSS for driving the light-emitting elements LD of the display panel 10 from the main power and supply them to the high-potential voltage line VDDL and the low-potential voltage line VSSL of the display panel 10. In addition, the power supply circuit 50 may generate and supply driving voltages for driving the driving circuit 20 and the scan driving unit 30 from the main power.

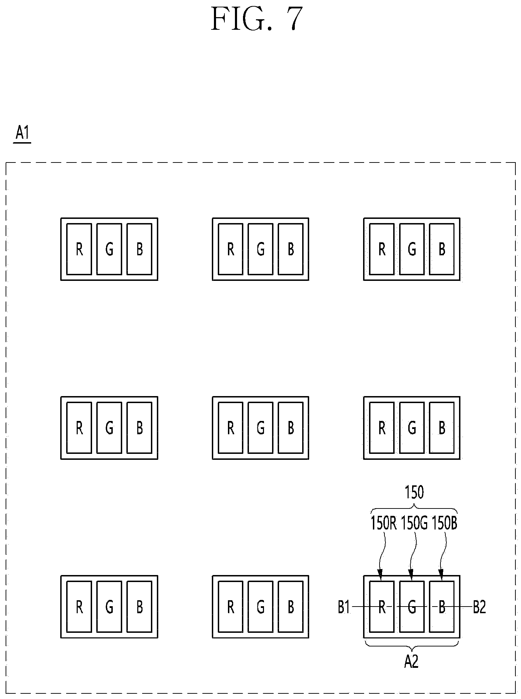

FIG. 7 is an enlarged view of a first panel region in the display device of FIG. 4.

Referring to FIG. 7, the display device 100 of the embodiment may be manufactured by mechanically and electrically connecting a plurality of panel regions such as the first panel region A1 by tiling.

The first panel region A1 may comprise a plurality of semiconductor light-emitting elements 150 disposed for each unit pixel (PX of FIG. 5).

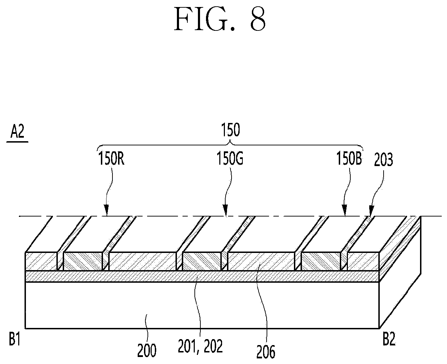

FIG. 8 is an enlarged view of a region A2 of FIG. 7.

Referring to FIG. 8, the display device 100 of the embodiment may comprise a substrate 200, assembly wirings 201 and 202, an insulating layer 206, and a plurality of semiconductor light-emitting elements 150. More components may be included than these.

The assembly wirings may comprise a first assembly wiring 201 and a second assembly wiring 202 that are spaced apart from each other. The first assembly wiring 201 and the second assembly wiring 202 may be provided to generate a dielectrophoretic force (DEP force) to assemble the semiconductor light-emitting element 150. For example, the semiconductor light-emitting element 150 may be one of a lateral-type semiconductor light-emitting element, a flipchip type semiconductor light-emitting element, and a vertical-type semiconductor light-emitting element.

The semiconductor light-emitting element 150 may comprise a red semiconductor light-emitting element 150R, a green semiconductor light-emitting element 150G, and a blue semiconductor light-emitting element 150B to form a unit pixel, but is not limited thereto, and may comprise a red phosphor and a green phosphor to implement red and green, respectively.

The substrate 200 may be a support member that supports components disposed on the substrate 200 or a protective member that protects the components.

The substrate 200 may be a rigid substrate or a flexible substrate. The substrate 200 may be formed of sapphire, glass, silicon, or polyimide. In addition, the substrate 200 may comprise a flexible material such as polyethylene naphthalate (PEN), polyethylene terephthalate (PET). In addition, the substrate 200 may be a transparent material, but is not limited thereto. The substrate 200 may function as a support substrate in a display panel, and may also function as an assembly substrate when self-assembling a light-emitting element.

The substrate 200 may be a backplane equipped with circuits, such as transistors ST and DT, capacitors Cst, and signal wiring, within the subpixels PX1, PX2, and PX3 illustrated in FIGS. 5 and 6, but is not limited thereto.

The insulating layer 206 may comprise an organic material having insulating and flexibility, such as polyimide, PAC, PEN, PET, polymer, etc., or an inorganic material such as silicon oxide (SiO₂) or silicon nitride series (SiNx), and may be formed integrally with the substrate 200 to form a single substrate.

The insulating layer 206 may be a conductive adhesive layer having adhesive properties and conductivity, and the conductive adhesive layer may have flexibility to enable a flexible function of the display device. For example, the insulating layer 206 may be a conductive adhesive layer such as an anisotropic conductive film (ACF) or an anisotropic conductive medium, a solution containing conductive particles, etc. The conductive adhesive layer may be a layer that is electrically conductive in a direction vertical to the thickness, but electrically insulating in a direction horizontal to the thickness.

The insulating layer 206 may comprise an assembly hole 203 for inserting a semiconductor light-emitting element 150. Therefore, when self-assembling, the semiconductor light-emitting element 150 may be easily inserted into the assembly hole 203 of the insulating layer 206. The assembly hole 203 may be called an insertion hole, a fixing hole, an alignment hole, etc. The assembly hole 203 may also be called a hole.

The assembly hole 203 may be called a hole, a groove, a recess, a pocket, etc.

The assembly hole 203 may be different depending on a shape of the semiconductor light-emitting element 150. For example, the red semiconductor light-emitting element, the green semiconductor light-emitting element, and the blue semiconductor light-emitting element each have different shapes, and the assembly holes 203 having shapes corresponding to shapes of the semiconductor light-emitting devices may be provided. For example, the assembly hole 203 may comprise a first assembly hole for assembling the red semiconductor light-emitting element, a second assembly hole for assembling the green semiconductor light-emitting element, and a third assembly hole for assembling the blue semiconductor light-emitting element. For example, the red semiconductor light-emitting element may have a circular shape, the green semiconductor light-emitting element may have a first oval shape having a first minor axis and a first major axis, and the blue semiconductor light-emitting element may have a second oval shape having a second minor axis and a second major axis, but is not limited thereto. The second major axis of the oval shape of the blue semiconductor light-emitting element may be greater than the second major axis of the oval shape of the green semiconductor light-emitting element, and the second minor axis of the oval shape of the blue semiconductor light-emitting element may be shorter than the first minor axis of the oval shape of the green semiconductor light-emitting element.

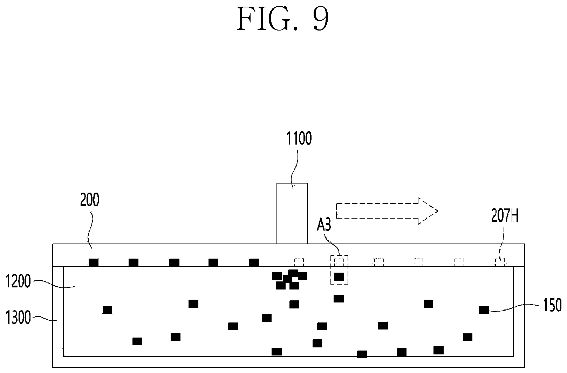

Meanwhile, the method of mounting the semiconductor light-emitting element 150 on the substrate 200 may comprise, for example, a self-assembly method (FIG. 9) and a transfer method.

FIG. 9 is a drawing illustrating an example of a light-emitting element according to an embodiment being assembled on a substrate by a self-assembly method.

Based on FIG. 9, an example of assembling a semiconductor light-emitting element according to an embodiment onto a display panel by a self-assembly method using an electromagnetic field will be described.

The assembled substrate 200 described below may also function as a panel substrate in a display device after assembling the light-emitting element, but the embodiment is not limited thereto.

Referring to FIG. 9, the semiconductor light-emitting element 150 may be put into a chamber 1300 filled with a fluid 1200, and the semiconductor light-emitting element 150 may be moved to the assembly substrate 200 by a magnetic field generated from the assembly device 1100. At this time, the light-emitting element 150 adjacent to the assembly hole 207H of the assembly substrate 200 may be assembled into the assembly hole 207H by the DEP force caused by an electric field of the assembly wirings. The fluid 1200 may be water such as ultrapure water, but is not limited thereto. The chamber may be called a tank, a container, a vessel, etc.

After the semiconductor light-emitting element 150 is put into the chamber 1300, the assembly substrate 200 may be disposed on the chamber 1300. According to an embodiment, the assembly substrate 200 may also be put into the chamber 1300.

The semiconductor light-emitting element 150 may be implemented as a vertical-type semiconductor light-emitting element as illustrated, but is not limited thereto, and a lateral-type light-emitting element may be employed.

The semiconductor light-emitting element 150 may comprise a magnetic layer (not illustrated) having a magnetic substance. The magnetic layer may comprise a metal having magnetism, such as nickel (Ni). Since the semiconductor light-emitting element 150 put into the fluid comprises the magnetic layer, it may move to the assembly substrate 200 by a magnetic field generated from the assembly device 1100. The magnetic layer may be disposed on an upper side, a lower side or both sides of the light-emitting element.

Meanwhile, the first assembly wiring 201 and the second assembly wiring 202 form an electric field as an AC voltage is applied, and the semiconductor light-emitting element 150 put into the assembly hole 207H may be fixed by the DEP force caused by the electric field. A gap between the first assembly wiring 201 and the second assembly wiring 202 may be smaller than a width of the semiconductor light-emitting element 150 and a width of the assembly hole 207H, and the assembly position of the semiconductor light-emitting element 150 may be more precisely fixed using an electric field.

An insulating layer 215 is formed on the first assembly wiring 201 and the second assembly wiring 202 to protect the first assembly wiring 201 and the second assembly wiring 202 from the fluid 1200 and prevent leakage of current flowing through the first assembly wiring 201 and the second assembly wiring 202. For example, the insulating layer 215 may be formed of an inorganic insulator such as silica or alumina, or an organic insulator in a single layer or multiple layers. The insulating layer 215 may have a minimum thickness to prevent damage to the first assembly wiring 201 and the second assembly wiring 202 during assembly of the semiconductor light-emitting element 150, and may have a maximum thickness to stably assemble the semiconductor light-emitting element 150.

A partition wall 207 may be formed on an upper part of the insulating layer 215. Some areas of the partition wall 207 may be positioned on the upper part of the first assembly wiring 201 and the second assembly wiring 202, and the remaining areas may be positioned on the upper part of the assembly substrate 200.

Meanwhile, when manufacturing the assembly substrate 200, a part of the partition wall formed on an upper part of the insulating layer 215 may be removed, thereby forming an assembly hole 207H in which each of the semiconductor light-emitting elements 150 is coupled and assembled to the assembly substrate 200.

An assembly hole 207H is formed in the assembly substrate 200, into which semiconductor light-emitting elements 150 are combined, and a surface on which the assembly hole 207H is formed may be in contact with a fluid 1200. The assembly hole 207H may guide an accurate assembly position of the semiconductor light-emitting element 150.

Meanwhile, the assembly hole 207H may have a shape and a size corresponding to a shape of the semiconductor light-emitting element 150 to be assembled at a corresponding position. Accordingly, another semiconductor light-emitting element may be assembled in the assembly hole 207H or a plurality of semiconductor light-emitting elements may be prevented from being assembled.

Referring again to FIG. 9, after the assembly substrate 200 is disposed in the chamber, an assembly device 1100 that applies a magnetic field may move along the assembly substrate 200. The assembly device 1100 may be a permanent magnet or an electromagnet.

The assembly device 1100 may move in contact with the assembly substrate 200 to maximize a region affected by the magnetic field within the fluid 1200. Depending on the embodiment, the assembly device 1100 may comprise a plurality of magnetic substances or may comprise magnetic substances of a size corresponding to the assembly substrate 200. In this instance, the movement distance of the assembly device 1100 may be limited within a predetermined range.

The semiconductor light-emitting element 150 within the chamber 1300 may move toward the assembly device 1100 and the assembly substrate 200 by the magnetic field generated by the assembly device 1100.

The semiconductor light-emitting element 150 may enter the assembly hole 207H and be fixed by the DEP force formed by the electric field between the assembly wirings 201 and 202 while moving toward the assembly device 1100.

Specifically, the first and second assembly wirings 201 and 202 form an electric field by an AC power source, and a DEP force may be formed between the assembly wirings 201 and 202 by the electric field. The semiconductor light-emitting element 150 may be fixed to the assembly hole 207H on the assembly substrate 200 by the DEP force.

At this time, a predetermined solder layer (not illustrated) is formed between the light-emitting element 150 assembled on the assembly hole 207H of the assembly substrate 200 and the assembly wirings 201 and 202, thereby improving the bonding strength of the light-emitting element 150.

In addition, a molding layer (not illustrated) may be formed on the assembly hole 207H of the assembly substrate 200 after assembly. The molding layer may be a transparent resin or a resin containing a reflective material or a scattering material.

Since the time required for each semiconductor light-emitting element to be assembled on the substrate may be drastically shortened by the self-assembly method using the electromagnetic field described above, a large-area, high-pixel display may be implemented more quickly and economically.

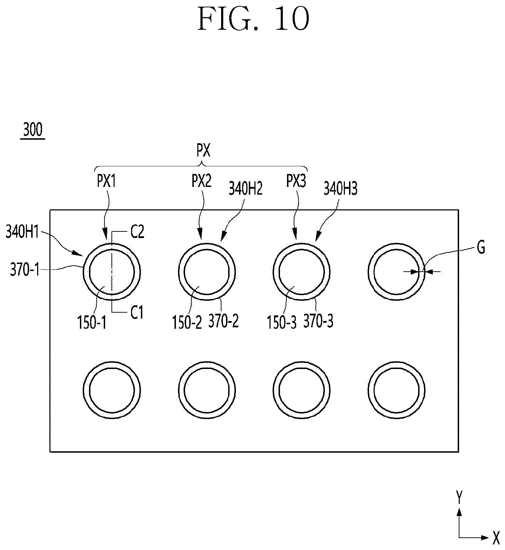

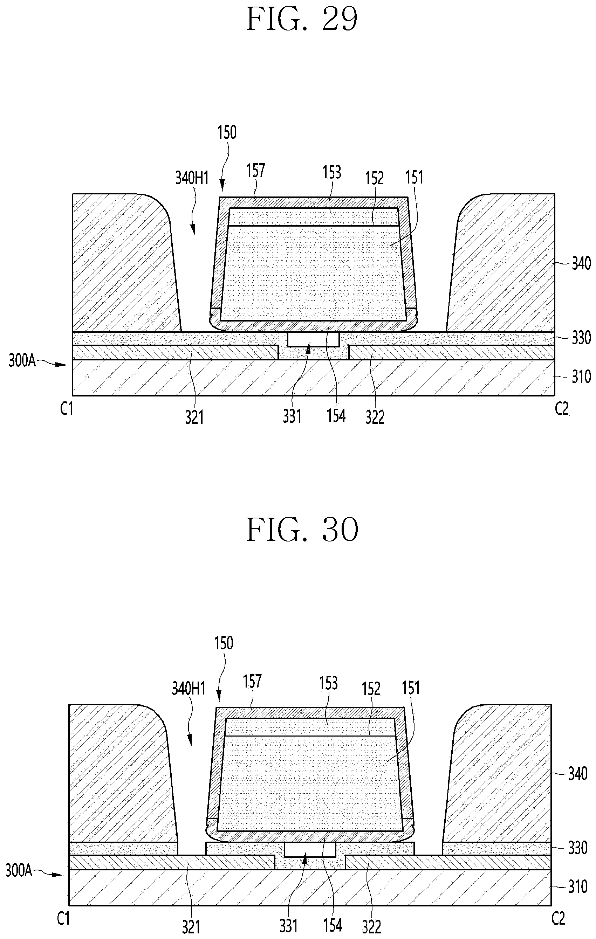

Hereinafter, various embodiments for solving the above-described problem will be described with reference to FIGS. 10 to 37. Any description omitted below may be easily understood from the description described above with respect to FIGS. 1 to 9 and the corresponding drawings.

FIG. 10 is a plan view illustrating a display device according to an embodiment.

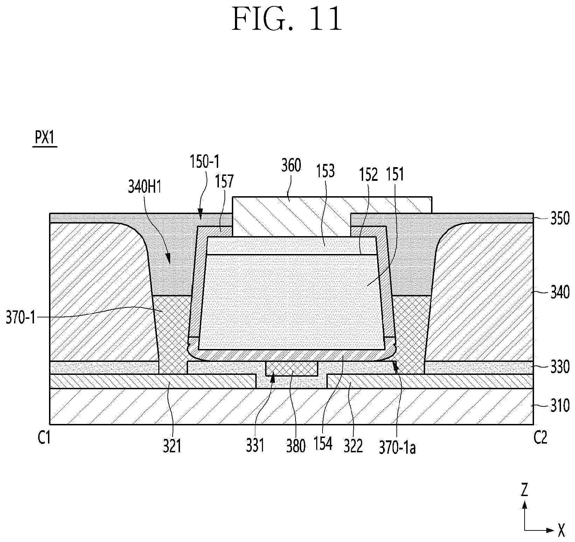

Referring to FIG. 10, the display device 300 according to an embodiment may define a plurality of subpixels PX1, PX2, and PX3 on a substrate (310 of FIG. 11). The plurality of subpixels PX1, PX2, and PX3 constitute a unit pixel PX, and a plurality of pixels PX may be arranged on the substrate 310. The plurality of pixels PX may be arranged in a matrix, but are not limited thereto.

The first subpixel PX1 may output a first color light, the second subpixel PX2 may output a second color light, and the third subpixel PX3 may output a third color light. The first color light, the second color light, and the third color light may have different wavelength bands. For example, the first color light may comprise red light, the second color light may comprise green light, and the third color light may comprise blue light. Accordingly, a full color image may be displayed by the red light, the green light, and the blue light. Although not illustrated, the unit pixel PX may further comprise an additional subpixel that outputs white light. The brightness of the unit pixel PX can be increased by the additional subpixel, thereby improving the contrast ratio.

A plurality of assembly holes 340H1, 340H2 and 340H3 may be provided on the substrate 310. The plurality of assembly holes 340H1, 340H2 and 340H3 may be formed as inwardly recessed grooves or recesses in a partition wall (340 in FIG. 11) to be described later.

The plurality of assembly holes 340H1, 340H2 and 340H3 may be provided in the plurality of subpixels PX1, PX2 and PX3, respectively. As an example, the first assembly hole 340H1 may be provided in the first subpixel PX1, the second assembly hole 340H2 may be provided in the second subpixel PX2, and the third assembly hole 340H3 may be provided in the third subpixel PX3. As another example, at least two or more first assembly holes 340H1 may be provided in the first subpixel PX1, at least two or more second assembly holes 340H2 may be provided in the second subpixel PX2, and at least two or more third assembly holes 340H3 may be provided in the third subpixel PX3.

A plurality of semiconductor light-emitting elements 150-1, 150-2, and 150-3 may be provided on the substrate 310. As an example, the first semiconductor light-emitting element 150-1 may be provided in the first subpixel PX1, the second semiconductor light-emitting element 150-2 may be provided in the second subpixel PX2, and the third semiconductor light-emitting element 150-3 may be provided in the third subpixel PX3. As another example, at least two or more first semiconductor light-emitting elements 150-1 may be provided in the first subpixel PX1, at least two or more second semiconductor light-emitting elements 150-2 may be provided in the second subpixel PX2, and at least two or more third semiconductor light-emitting elements 150-3 may be provided in the third subpixel PX3.

For example, the first semiconductor light-emitting element 150-1 may be disposed in the first assembly hole 340H1 on the first subpixel PX1, the second semiconductor light-emitting element 150-2 may be disposed in the second assembly hole 340H2 on the second subpixel PX2, and the third semiconductor light-emitting element 150-3 may be disposed in the third assembly hole 340H3 on the third subpixel PX3.

The first semiconductor light-emitting element 150-1, the second semiconductor light-emitting element 150-2, and the third semiconductor light-emitting element 150-3, which are respectively disposed in the first subpixel PX1, the second subpixel PX2, and the third subpixel PX3, must be fixed and electrically connected to the first subpixel PX1, the second subpixel PX2, and the third subpixel PX3.

In an embodiment, the fixing and electrical connection of the first semiconductor light-emitting element 150-1, the second semiconductor light-emitting element 150-2, and the third semiconductor light-emitting element 150-3 may be performed simultaneously using the same process.

The lateral part of each of the plurality of semiconductor light-emitting elements 150-1, 150-2 and 150-3 and the substrate 310, specifically the first assembly wiring (321 of FIG. 11) and the second assembly wiring 322, may be electrically connected by the plurality of connection electrodes 370-1, 370-2 and 370-3, respectively. **In** the drawing, the lateral part of each of the plurality of semiconductor light-emitting elements 150-1, 150-2 and 150-3 are illustrated as being connected to the first assembly wiring 321 and the second assembly wiring 322, but may also be connected to the first assembly wiring 321 or the second assembly wiring 322.

For example, when the lateral part of each of the plurality of semiconductor light-emitting elements 150-1, 150-2, and 150-3 is connected to the first assembly wiring 321 and the second assembly wiring 322, as illustrated in FIG. 10, each of the plurality of connection electrodes 370-1, 370-2, and 370-3 may be disposed along the perimeter of each of the plurality of semiconductor light-emitting elements 150-1, 150-2, and 150-3, thereby forming a closed loop. When connected to the first assembly wiring 321 or the second assembly wiring 322, each of the plurality of connection electrodes 370-1, 370-2 and 370-3 may be disposed along the perimeter of each of the plurality of semiconductor light-emitting elements 150-1, 150-2 and 150-3 on the first assembly wiring 321 or the second assembly wiring 322, thereby having an open loop in the shape of a hemisphere.

The lateral part of the first semiconductor light-emitting element 150-1 and the first assembly wiring 321 and the second assembly wiring 322 on the first subpixel PX1 may be electrically connected by the first connection electrode 370-1. The lateral part of the second semiconductor light-emitting element 150-2 and the first assembly wiring 321 and the second assembly wiring 322 on the second subpixel PX2 may be electrically connected by the second connection electrode 370-2. The lateral part of the third semiconductor light-emitting element 150-3 and the first assembly wiring 321 and the second assembly wiring 322 on the third subpixel PX3 may be electrically connected by the third connection electrode 370-3.

Although not illustrated, each of the plurality of semiconductor light-emitting elements 150-1, 150-2, and 150-3 may be fixed to the substrate 310, specifically, the insulating layer 330, by a fixing member (380 of FIG. 11).

In this instance, the plurality of connection electrodes 370-1, 370-2, and 370-3 and the fixing member 380 may be simultaneously formed using a series of processes, i.e., a coating process and a melting process, with the same metal powder. For example, the plurality of connection electrodes 370-1, 370-2, and 370-3 and the fixing member 380 may be each formed of at least one or more metal material.

By using a series of processes, i.e., a coating process and a melting process, with the same metal powder, the semiconductor light-emitting element 150-1 may be assembled into the assembly hole 340H1, so that even if the gap G between the outer side of the semiconductor light-emitting element 150-1 and the inner side of the assembly hole 340H1 is very narrow, the connection electrodes 370-1, 370-2 and 370-3 may be formed without a disconnection, and at the same time, the semiconductor light-emitting element 150-1 may be firmly fixed to the insulating layer 330 by the fixing member 380 formed below a lower side of the semiconductor light-emitting element 150-1.

As will be described in detail later, by coating a solution containing at least one type or more of metal particle (powder), the solution may flow downward through the gap G by gravity to fill the assembly hole 340H1, and the metal particles may be melted by a melting process, so that the connection electrodes 370-1, 370-2, and 370-3 and the fixing member 380 may be formed simultaneously within the assembly hole 340H1. Even when the gap G between the outer side of the semiconductor light-emitting element 150-1 and the inner side of the assembly hole 340H1 is 1.5 micrometers or less, the connection electrodes 370-1, 370-2, and 370-3 may be formed without a disconnection, so that high resolution or ultra-high resolution can be implemented and product reliability can be improved.

On the first subpixel PX1, the first connection electrode 370-1 may be spaced apart from the fixed member 380, but may also be in contact with each other. On the second subpixel PX2, the second connection electrode 370-2 may be spaced apart from the fixed member 380, but may also be in contact with each other. On the third subpixel PX3, the third connection electrode 370-3 may be spaced apart from the fixed member 380, but may also be in contact with each other.

Hereinafter, a method and structure for forming a plurality of connection electrodes 370-1, 370-2, and 370-3 and the fixed member 380 simultaneously through various embodiments are described.

FIG. 11 is a cross-sectional view illustrating a first subpixel according to a first embodiment.

The structures of the second subpixel PX2 and the third subpixel PX3 are the same as a structure of the first subpixel PX1, except for the second semiconductor light-emitting element 150-2 and the third semiconductor light-emitting element 150-3 as light sources. Therefore, the structures of the second subpixel PX2 and the third subpixel PX3 may be easily understood from the structure of the first subpixel PX1.

Hereinafter, the first insulating layer 330 may be used interchangeably with the insulating layer, the first semiconductor light-emitting element 150-1 may be used interchangeably with the semiconductor light-emitting element, and the first assembly hole 340H1 may be used interchangeably with the assembly hole.

Referring to FIG. 11, the first subpixel PX1 according to the first embodiment may comprise a substrate 310, a first assembly wiring 321, a second assembly wiring 322, an insulating layer 330, a partition wall 340, a semiconductor light-emitting element 150-1, a fixing member 380, and a connection electrode 370-1.

The substrate 310 may be a supporting member that supports components disposed on the substrate 310 or a protective member that protects the components.

The first assembly wiring 321 and the second assembly wiring 322 may be disposed on the substrate 310. For example, the first assembly wiring 321 and the second assembly wiring 322 may be disposed on the same layer. For example, the first assembly wiring 321 and the second assembly wiring 322 may be in contact with an upper surface of the substrate 310, but is not limited thereto. For example, the first assembly wiring 321 and the second assembly wiring 322 may be disposed in parallel with each other. The first assembly wiring 321 and the second assembly wiring 322 may play a role in assembling the semiconductor light-emitting element 150-1 into the assembly hole 340H1 in a self-assembly manner. That is, when self-assembling, an electric field may be generated between the first assembly wiring 321 and the second assembly wiring 322 by a voltage supplied to the first assembly wiring 321 and the second assembly wiring 322, and the semiconductor light-emitting element 150-1 moving by the assembly device (1100 of FIG. 9) may be assembled into the assembly hole 340H1 by the dielectrophoretic force formed by the electric field.

The insulating layer 330 may be disposed on the substrate 310. For example, the insulating layer 330 may be made of an inorganic material or an organic material. For example, the insulating layer 330 may be made of a material having a permittivity related to a dielectric force, and may contribute to a size of the DEP force formed between the first assembly wiring 321 and the second assembly wiring 322. The insulating layer 330 may protect the first assembly wiring 321 and the second assembly wiring 322.

The partition wall 340 may be disposed on the first assembly wiring 321 and the second assembly wiring 322. The partition wall 340 may have an assembly hole 340H1 for assembling the semiconductor light-emitting element 150-1. For example, the insulating layer 330 may be exposed within the assembly hole 340H1. For example, a bottom surface of the assembly hole 340H1 may be an upper surface of the insulating layer 330.

A thickness of the partition wall 340 may be determined by considering a thickness of the semiconductor light-emitting element 150-1. For example, the thickness of the partition wall 340 may be smaller than the thickness of the semiconductor light-emitting element 150-1. Accordingly, the upper side of the semiconductor light-emitting element 150-1 may be positioned higher than the upper surface of the partition wall 340. That is, the upper side of the semiconductor light-emitting element 150-1 may protrude upward from the upper surface of the partition wall 340. As another example, the thickness of the partition wall 340 may be similar to or the same as the thickness of the semiconductor light-emitting element 150-1.

A size of the assembly hole 340H1 may be determined by considering a tolerance margin for forming the assembly hole 340H1 and a margin for easily assembling the semiconductor light-emitting element 150-1 within the assembly hole 340H1. For example, the size of the assembly hole 340H1 may be greater than the size of the semiconductor light-emitting element 150-1. When the size of the assembly hole 340H1 is too large, the size of the subpixel PX1 may increase, which may hinder the implementation of high resolution. Accordingly, for example, when the semiconductor light-emitting element 150-1 is assembled at the center of the assembly hole 340H1, a distance between the outer side of the semiconductor light-emitting element 150-1 and the inner side of the assembly hole 340H1 may be 1.5µm or less, but is not limited thereto. Accordingly, high resolution or ultra-high resolution implementation can be possible.

For example, the assembly hole 340H1 may have a shape corresponding to a shape of the semiconductor light-emitting element 150-1. For example, when the semiconductor light-emitting element 150-1 is circular, the assembly hole 340H1 may also be circular. For example, when the semiconductor light-emitting element 150-1 is rectangular, the assembly hole 340H1 may also be rectangular.

Meanwhile, the semiconductor light-emitting element 150-1 may be disposed in the assembly hole 340H1.

As described above, the semiconductor light-emitting element 150-1 may emit first color light, i.e., red light. In this instance, the second semiconductor light-emitting element 150-2 on the second subpixel PX2 may emit green light, and the third semiconductor light-emitting element 150-3 on the third subpixel PX3 may emit blue light, but is not limited thereto.

For example, during self-assembly, the first semiconductor light-emitting element 150-1, the second semiconductor light-emitting element 150-2, and the third semiconductor light-emitting element 150-3 distributed in the same chamber (1300 of FIG. 9) may be simultaneously moved by the same assembly device 1100 and assembled into the assembly holes 340H1, 340H2, and 340H3 of the corresponding subpixels (PX1, PX2, PX3 of FIG. 10), respectively.

When the sizes of the assembly holes 340H1, 340H2 and 340H3 of the subpixels PX1, PX2 and PX3, respectively, are the same, the first semiconductor light-emitting element 150-1, the second semiconductor light-emitting element 150-2 and the third semiconductor light-emitting element 150-3 may not be assembled into the assembly holes 340H1, 340H2 and 340H3 into which they are to be assembled, but may be assembled into other assembly holes. To solve this problem, the shapes of the first semiconductor light-emitting element 150-1, the second semiconductor light-emitting element 150-2 and the third semiconductor light-emitting element 150-3, respectively, may be different, and the assembly holes 340H1, 340H2 and 340H3 may be formed to correspond to the different shapes of the first semiconductor light-emitting element 150-1, the second semiconductor light-emitting element 150-2 and the third semiconductor light-emitting element 150-3, respectively. Accordingly, since the first semiconductor light-emitting element 150-1, the second semiconductor light-emitting element 150-2, and the third semiconductor light-emitting element 150-3, each having a different shape, are assembled into the assembly holes 340H1, 340H2, and 340H3 corresponding to their shapes, assembly defects may be prevented.

The semiconductor light-emitting element 150-1 of the embodiment may be a vertical-type semiconductor light-emitting element.

As illustrated in FIG. 11, the semiconductor light-emitting element 150-1 may comprise a light-emitting portion 151, 152, and 153, an electrode 154, and a passivation layer 157. The semiconductor light-emitting element 150-1 may comprise more components than these.

The light-emitting portion 151, 152, and 153 comprise a first conductivity type semiconductor layer 151, an active layer 152, and a second conductivity type semiconductor layer 153, but may comprise more components. The first conductivity type semiconductor layer 151 may comprise a first conductive dopant, and the second conductivity type semiconductor layer 153 may comprise a second conductive dopant. For example, the first conductive dopant may be an n-type dopant, such as silicon (Si), and the second conductive dopant may be a p-type dopant, such as boron (B).

An electrode 154 may be disposed on a lower side of the first conductivity type semiconductor layer 151. The electrode 154 may comprise at least one or more layer.

In an embodiment, the electrode 154 may be disposed on a lateral part of the first conductivity type semiconductor layer 151 for contact with the connection electrode 370-1. Additionally, the electrode 154 may be disposed on a lower side of the first conductivity type semiconductor layer 151.

Although not illustrated, another electrode may be disposed on an upper side of the second conductivity type semiconductor layer 153. Another electrode may comprise a transparent conductive layer such as ITO.

The passivation layer 157 may protect the light-emitting portion 151, 152, and 153. For example, the passivation layer 157 may surround the light-emitting portion 151, 152, and 153. The passivation layer 157 has a permittivity, and thus may affect the size of the DEP force formed between the first assembly wiring 321 and the second assembly wiring 322 during self-assembly. For example, when the electrode 154 is disposed on the lower side of the light-emitting portion 151, 152, and 153, and the remaining lateral parts of the light-emitting portion 151, 152, and 153 are surrounded by the passivation layer 157, the first conductivity type semiconductor layer 151 may be adjusted to face the assembly hole 340H1 and the second conductivity type semiconductor layer 153 may face forward by the DEP force formed in the assembly hole 340H1. Accordingly, the semiconductor light-emitting element 150-1 may be correctly-assembled in the assembly hole 340H1 without being turned over.

Meanwhile, as will be described later, the connection electrode 370-1 and the fixing member 380 may be formed using the same deposition process with the same metal, so that fixing and electrical connection of the semiconductor light-emitting element 150-1 may be performed simultaneously. For example, the connection electrode 370-1 and the fixing member 380 may be made of the same metal. The connection electrode 370-1 and the fixing member 380 may be made of at least one or more metal. The fixing member may be called a fixing pattern or a fixing layer.

The connection electrode 370-1 may be disposed between the outer side of the semiconductor light-emitting element 150-1 and the inner side of the assembly hole 340H1. The connection electrode 370-1 may be disposed along the perimeter of the semiconductor light-emitting element 150-1 within the assembly hole 340H1. The lateral part of the connection electrode 370-1 may be in contact with the lateral part of the semiconductor light-emitting element 150-1, that is, the lateral part of the electrode 154, and the lower side of the connection electrode 370-1 may penetrate the insulating layer 330 and be in contact with the upper surface of each of the first assembly wiring 321 and/or the second assembly wiring 322.

Meanwhile, a part 370-1a of the connection electrode 370-1 may extend between the semiconductor light-emitting element 150-1 and the insulating layer 330. The part 370-1a of the connection electrode 370-1 may extend between the lower surface of the semiconductor light-emitting element 150-1 and the upper surface of the insulating layer 330, so that the fixation of the semiconductor light-emitting element 150-1 can be strengthened by the connection electrode 370-1.

The fixing member 380 may be disposed in the recess 331. The recess 331 may be formed in the insulating layer 330. The recess 331 may be in contact with the assembly hole 340H1.

The fixing member 380 may be disposed between the first assembly wiring 321 and the second assembly wiring 322. The fixing member 380 may be disposed between the lower surface of the semiconductor light-emitting element 150-1 and the upper surface of the insulating layer 330. The fixing member 380 may be disposed between the first assembly wiring 321 and the second assembly wiring 322 and between the lower surface of the semiconductor light-emitting element 150-1 and the upper surface of the insulating layer 330.

As an example, the recess 331 may be formed on the insulating layer 330 between the first assembly wiring 321 and the second assembly wiring 322. The depth of the recess 331 may be determined by the separation distance between the first assembly wiring 321 and the second assembly wiring 322, the thickness of the insulating layer 330, the thickness of the first assembly wiring 321, and/or the thickness of the second assembly wiring 322. The thickness of the insulating layer 330 may be smaller than the thickness of the first assembly wiring 321 or the thickness of the second assembly wiring 322.

As another example, although not illustrated, the recess 331 may be formed by etching the upper surface of the insulating layer 330. When the thickness of the insulating layer 330 is greater than the thickness of the first assembly wiring 321 or the thickness of the second assembly wiring 322, the recess 331 may be formed by etching the upper surface of the insulating layer 330 corresponding to between the first assembly wiring 321 and the second assembly wiring 322.

As another example, although not illustrated, the recess 331 may be formed by etching the upper/lower surface of the insulating layer 330 corresponding to between the first assembly wiring 321 and the second assembly wiring 322 so as to expose the upper surface of the substrate 310.

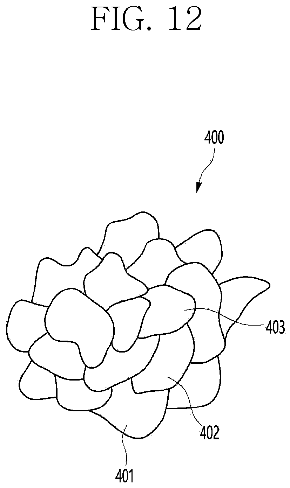

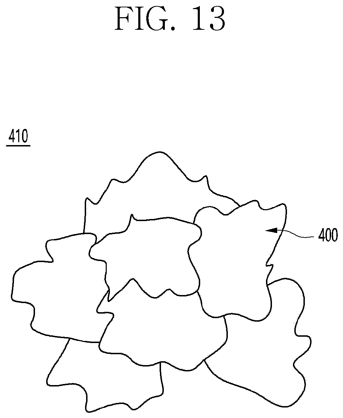

Meanwhile, the connection electrode 370-1 and the fixing member 380 may comprise an aggregate 410 of lumps 400 in which a plurality of conductive nanoparticles 401, 402, and 403 are entangled with each other, as illustrated in FIGS. 12 and 13.

For example, the conductive nanoparticles may comprise, but are not limited to, electrode particles 401, magnetization particles 402, reflection particles 403, etc.

The electrode particle 401 may be a metal having excellent electrical conductivity, such as copper (Cu). The electrode particle 401 may function as an electrode for smooth current flow between the semiconductor light-emitting element 150-1 and the first assembly wiring 321 or the second assembly wiring 322. The magnetization particle 402 may be a metal having excellent magnetization characteristics, such as nickel (Ni). The magnetization particle 402 may be easily magnetized by a magnet during self-assembly, so that the semiconductor light-emitting element 150-1 can quickly and accurately move to the assembly hole 340H1 of the corresponding subpixel PX1 on the substrate 310. The reflective particle 403 may be a metal having excellent reflective characteristics, such as aluminum (Al). The reflective particle 403 may reflect light generated from the semiconductor light-emitting element 150-1 forward, thereby improving light efficiency and luminance of the semiconductor light-emitting element 150-1.

The electrode powder comprising the electrode particles 401 dispersed in the solution, the magnetization powder comprising the magnetization particles 402, and the reflective powder comprising the reflective particles 403 may be melted by a melting process, so that the electrode particles 401, the magnetization particles 402, and the reflective particles 403 can be entangled with each other, as illustrated in FIG. 12. The surface shapes of the electrode particles 401, the magnetization particles 402, and the reflective particles 403 melted by the melting process may vary, such as a constant round surface, a random round surface, an uneven surface, etc. The solution may contain a solvent such as an organic solvent or water, and various additives. The additives may contain a dispersant, an organic binder, a surfactant, etc.

The electrode particles 401, the magnetization particles 402, and the reflective particles 403 may be entangled one-dimensionally, two-dimensionally, or three-dimensionally. Multiple electrode particles 401, magnetization particles 402, or reflection particles 403 may be entangled in a row. The electrode particles 401, magnetization particles 402, and reflection particles 403 may be entangled one by one. Multiple magnetization particles 402 may be entangled between adjacent electrode particles 401. Multiple magnetization particles 402 may be entangled between adjacent magnetization particles 402. Multiple electrode particles 401 may be entangled between adjacent reflection particles 403. The electrode particles 401, magnetization particles 402, and reflection particles 403 may be entangled with each other in various combinations.

The electrode particles 401, the magnetization particles 402, and the reflection particles 403 may be entangled with each other in various combinations to form a lump 400 as illustrated in FIG. 12. A number of lumps 400 may be combined to form an aggregate 410 as illustrated in FIG. 13. Although not illustrated, the electrode particles 401, the magnetization particles 402, and the reflection particles 403 may be formed into an aggregate 410 by skipping the lump 400 by entangling each other in various combinations.

Such an aggregate 410 may be formed with a preset thickness to become the connection electrode 370-1 or the fixing member 380. The preset thickness may be a thickness set for the connection electrode 370-1 or the fixing member 380.

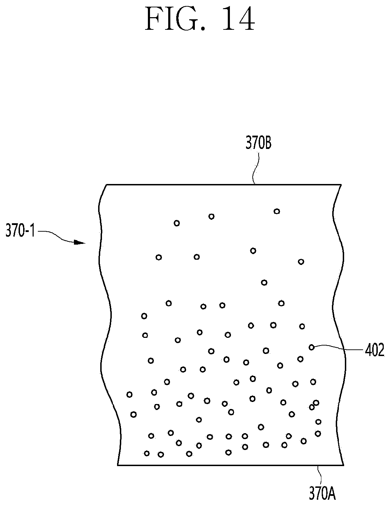

Meanwhile, as illustrated in FIG. 14, the density of the magnetization particles 402 may increase as it goes from an upper surface 370B of the connecting electrode 370-1 to a lower surface 370A of the connecting electrode 370-1 or as it goes away from the upper surface 370B of the connecting electrode 370-1.

For smooth current flow, it is desirable for the dedicated particles to be entangled with each other and make electrical contact. However, even if there are many electrode particles 401 in the connection electrode 370-1, there may be many places where the electrode particles 401 are not entangled with each other in the connection electrode 370-1. In such cases, smooth current flow is difficult, which may lead to a decrease in the luminance of the semiconductor light-emitting element 150-1.

To solve this problem, after a solution in which electrode powder, magnetization powder, and reflective powder are dispersed is applied on the substrate 310, a magnet may be positioned below the substrate 310. Among the electrode powder, magnetization powder, and reflective powder dispersed in the applied solution, the magnetization powder can quickly descend toward the substrate 310 by the magnet.

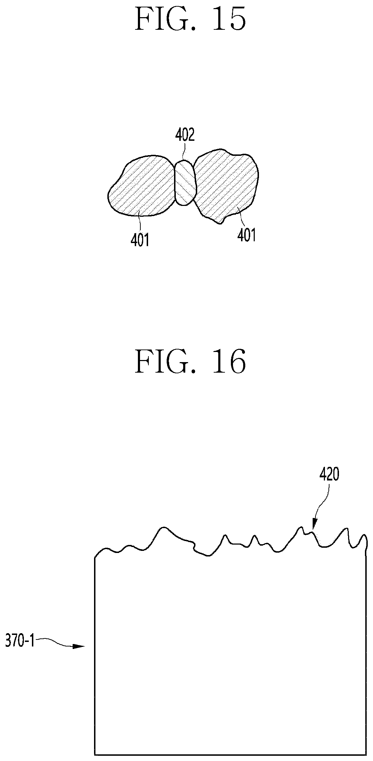

Thereafter, the electrode particles 401 of the electrode powder, the magnetization particles 402 of the magnetization powder, and the reflective particles 403 of the reflective powder may be melted by a melting process, so that the connection electrode 370-1 and the fixing member 380 may be formed. Since the magnetization powder is dispersed in large amounts in a region adjacent to the substrate 310 by the magnet, as illustrated in FIG. 15, the electrode particles 401 may be electrically connected via the magnetization particles 402 included in the magnetization powder during the melting process, thereby enabling smooth current flow.

More magnetization particles 402 may be included in a lower region than in an upper region or a middle region of the connection electrode 370-1, so that the electrode particles 401 may be electrically connected by the magnetization particles 402. Accordingly, the resistance may be lower in the lower region than in the upper region or the middle region within the connection electrode 370-1, and the lower region of the connection electrode 370-1 may be connected to the first assembly wiring 321 and/or the second assembly wiring 322. Accordingly, a smoother current flow is possible between the semiconductor light-emitting element 150-1 and the first assembly wiring 321 and/or the second assembly wiring 322 by the lower region of the connection electrode 370-1, so that it can contribute to improving the luminance of the semiconductor light-emitting element 150-1.

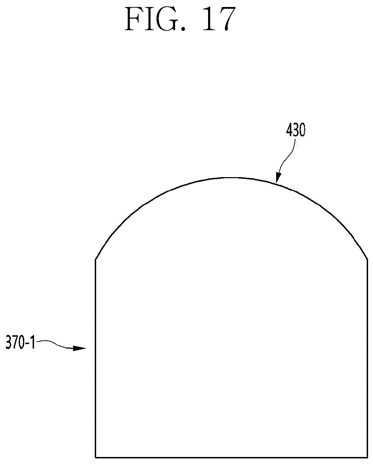

Meanwhile, as described above, since the connection electrode 370-1 of the embodiment is formed by melting various powders included in the solution through a melting process, the upper surface of the connection electrode 370-1 may have various shapes. For example, the upper surface of the connection electrode 370-1 may have various shapes, such as an uneven surface (420 of FIG. 16) or a round surface (430 of FIG. 17).

Referring again to FIG. 11, the first subpixel PX1 according to the first embodiment may comprise a second insulating layer 350 and an electrode wiring 360.

The second insulating layer 350 may protect the semiconductor light-emitting element 150-1. The second insulating layer 350 may be a planarization layer for preventing electrical disconnection of the electrode wiring 360. That is, an upper surface of the second insulating layer 350 may have a flat, straight surface. The second insulating layer 350 may be formed of an organic material, but is not limited thereto.

The second insulating layer 350 may be disposed on the partition wall 340. The second insulating layer 350 may be disposed on the semiconductor light-emitting element 150-1. The second insulating layer 350 may be disposed between the outer side of the semiconductor light-emitting element 150-1 and the inner side of the assembly hole 340H1.

The electrode wiring 360 may be disposed on the second insulating layer 350 and may be electrically connected to the semiconductor light-emitting element 150-1 through the second insulating layer 350.

For example, the electrode wiring 360 may be electrically connected to the second conductivity type semiconductor layer 153 through the second insulating layer 350 and the passivation layer 157 of the semiconductor light-emitting element 150-1. When a second electrode is disposed on the second conductivity type semiconductor layer 153, the electrode wiring 360 may be connected to the second electrode.

The first assembly wiring 321 and/or the second assembly wiring 322 may be referred to as a lower electrode wiring, and the electrode wiring 360 may be referred to as an upper electrode wiring.

In the first subpixel PX1 according to the first embodiment configured as described above, a first color light, for example, red light, may be emitted from the semiconductor light-emitting element 150-1 by a positive voltage applied to the electrode wiring 360 and a negative voltage applied to the first assembly wiring 321 and/or the second assembly wiring 322.

Although not illustrated, a second color light, for example, green light, may be emitted from the second semiconductor light-emitting element 150-2 of the second subpixel PX2, and a third color light, for example, blue light, may be emitted from the third semiconductor light-emitting element 150-3 of the third subpixel PX3. Accordingly, a full color image may be displayed on the unit pixel PX constituting the first subpixel PX1, the second subpixel PX2, and the third subpixel.

Hereinafter, a display manufacturing process according to an embodiment will be described.

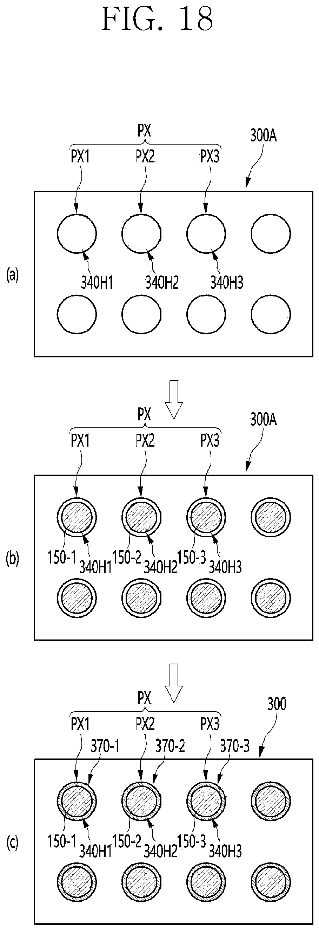

FIG. 18 illustrates a display device manufactured using a backplane substrate.

As illustrated in FIG. 18(a), a backplane substrate 300A may be provided. The backplane substrate 300A comprises a plurality of subpixels PX1, PX2, and PX3, and assembly holes 340H1, 340H2 and 340H3 may be formed in the plurality of subpixels PX1, PX2, and PX3, respectively. The plurality of subpixels may comprise, for example, a first subpixel PX1, a second subpixel PX2, and a third subpixel PX3, but is not limited thereto. In this instance, a unit pixel PX may be configured by the first subpixel PX1, the second subpixel PX2, and the third subpixel PX3. The plurality of pixels PX may be arranged in a matrix on the backplane substrate 300A.

As illustrated in FIG. 18(b), a plurality of semiconductor light-emitting elements 150-1, 150-2, and 150-3 may be assembled on the backplane substrate 300A using a self-assembly process. The plurality of semiconductor light-emitting elements may comprise a first semiconductor light-emitting element 150-1, a second semiconductor light-emitting element 150-2, and a third semiconductor light-emitting element 150-3. The first semiconductor light-emitting element 150-1 may be assembled into the first assembly hole 340H1 of the first subpixel PX1, the second semiconductor light-emitting element 150-2 of the second subpixel PX2 may be assembled into the second assembly hole 340H2 of the second subpixel PX2, and the third semiconductor light-emitting element 150-3 may be assembled into the third assembly hole 340H3 of the third subpixel PX3.

When self-assembling, the first semiconductor light-emitting element 150-1, the second semiconductor light-emitting element 150-2, and the third semiconductor light-emitting element 150-3 may be assembled on the backplane substrate 300A simultaneously or individually. By making the shapes of the first semiconductor light-emitting element 150-1, the second semiconductor light-emitting element 150-2, and the third semiconductor light-emitting element 150-3 different, when the first semiconductor light-emitting element 150-1, the second semiconductor light-emitting element 150-2, and the third semiconductor light-emitting element 150-3 are simultaneously assembled on the backplane substrate 300A, incorrect assembly in which they are assembled into assembly holes other than the self-assembly holes may be prevented, but is not limited thereto.

As illustrated in FIG. 18(c), a plurality of connection electrodes 370-1, 370-2, and 370-3 may be formed in a plurality of assembly holes 340H1, 340H2, and 340H3 by a process of applying a solution comprising a metal powder and a process of melting. A first connection electrode 370-1 may be formed around the first semiconductor light-emitting element 150-1 in the first assembly hole 340H1 of the first subpixel PX1, a second connection electrode 370-2 may be formed around the second semiconductor light-emitting element 150-2 in the second assembly hole 340H2 of the second subpixel PX2, and a third connection electrode 370-3 may be formed around the third semiconductor light-emitting element 150-3 in the third assembly hole 340H3 of the third subpixel PX3.

Although not illustrated, a plurality of fixing members 380 may be formed on the plurality of subpixels PX1, PX2, and PX3 simultaneously with the plurality of connection electrodes 370-1, 370-2, and 370-3.

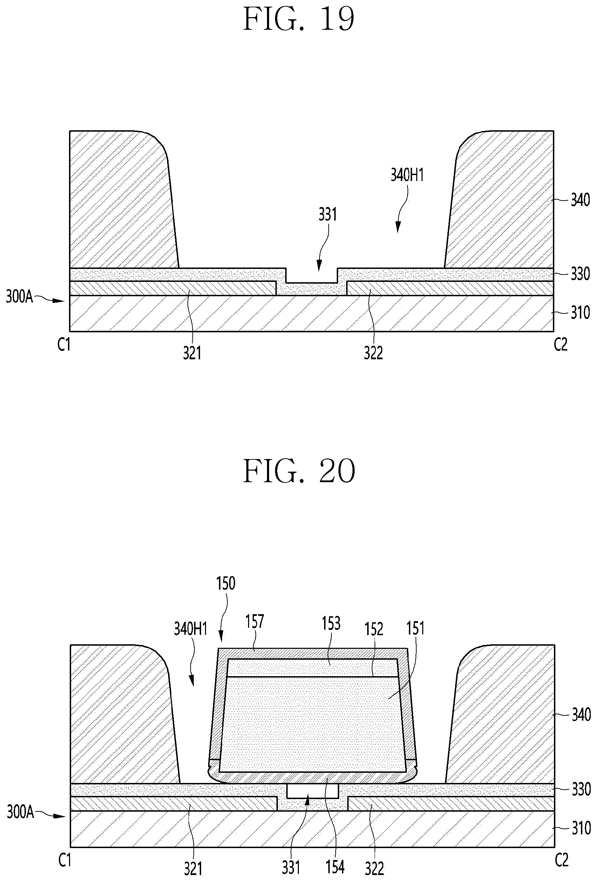

FIGS. 19 to 26 illustrate a manufacturing process of a first subpixel according to a first embodiment.

For the convenience of explanation, it is limited to the first subpixel PX1, but since the manufacturing process of each of the second subpixel PX2 and the third subpixel PX3 is also the same as the manufacturing process of the first subpixel PX1, the manufacturing process of each of the second subpixel PX2 and the third subpixel PX3 may be easily understood from the manufacturing process of the first subpixel PX1.

As illustrated in FIG. 19, a backplane substrate 300A may be provided. A first assembly wiring 321, a second assembly wiring 322, and an assembly hole 340H1 may be formed on the backplane substrate 300A. The assembly hole 340H1 may vertically overlap a part of the first assembly wiring 321 and a part of the second assembly wiring 322. Accordingly, a DEP force formed by the first assembly wiring 321 and the second assembly wiring 322 may be formed within the assembly hole 340H1.

Meanwhile, a recess 331 may be formed at a bottom part of the assembly hole 340H1. That is, the recess 331 may be in contact with the assembly hole 340H1. The recess 331 may be formed in the insulating layer 330. The recess 331 may be formed in the insulating layer 330 between the first assembly wiring 321 and the second assembly wiring 322. The size and depth of the recess 331 may be determined by the thickness of the insulating layer 330, the thickness of each of the first assembly wiring 321 and/or the second assembly wiring 322, and a separation distance between the first assembly wiring 321 and the second assembly wiring 322.

As illustrated in FIG. 20, a DEP force may be formed in the assembly hole 340H1 by a voltage applied to the first assembly wiring 321 and the second assembly wiring 322. Although not illustrated, the semiconductor light-emitting element 150-1 in the fluid on the backplane substrate 300A may be moved to the position of the assembly hole 340H1 by the movement of the magnet positioned below the backplane. The semiconductor light-emitting element 150-1 may be assembled into the assembly hole 340H1 by the DEP force.

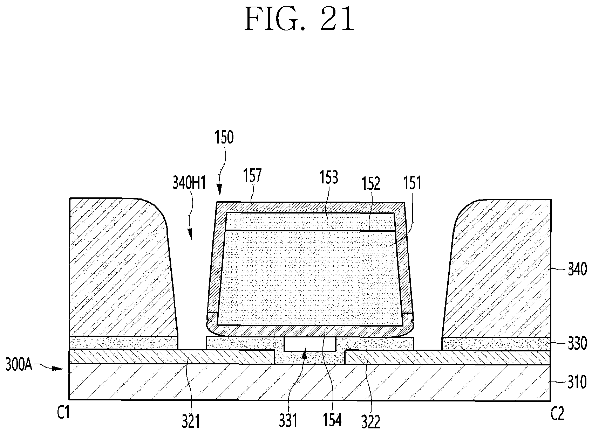

As illustrated in FIG. 21, an etching process may be performed so that the insulating layer 330 in the assembly hole 340H1 may be removed, thereby exposing a part of an upper surface of each of the first assembly wiring 321 and/or the second assembly wiring 322. At this time, a voltage may be continuously applied to the first assembly wiring 321 and/or the second assembly wiring 322, so that the semiconductor light-emitting element 150-1 assembled into the assembly hole 340H1 by the DEP force does not fall out of the assembly hole 340H1.

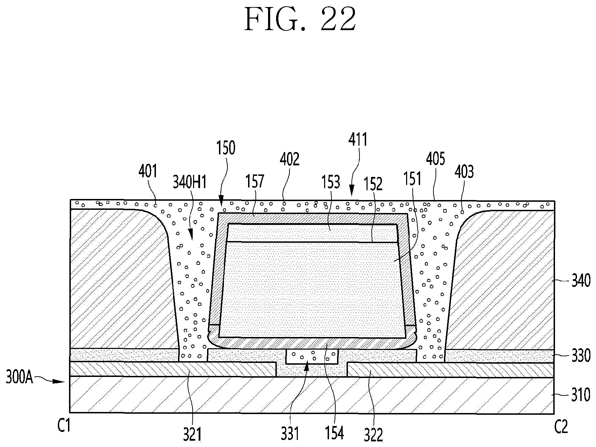

As illustrated in FIG. 22, a solution 411 in which metal powder is dispersed may be applied on a substrate 310. The solution 411 may comprise a solvent 405 such as an organic solvent or water and various additives. Accordingly, the metal powder or additives may be mixed with the solvent 405 to produce the solution 411. At this time, the solution 411 may be a low viscosity solution of 1,000 Cp or less.

The organic solvent may comprise acetone, ethanol, IPA, MEK, PGMEA, toluene, EC, EMC, DMC, etc. The metal powder may comprise electrode powder, magnetization powder, reflection powder, etc. The metal powder may be a low melting-point nano powder having a melting point of 300°C or less and a size of 1 micrometer or less. Since the electrode powder must have a melting point of 300°C or lower, it may comprise Sn, In, SnAg, SnCu, SnAu, SnBi, SnPb, etc. Additives may comprise a dispersant, an organic binder, a surfactant, etc.

When the melting process described below is performed under process conditions exceeding 300°C, the electrical/optical characteristics of the semiconductor light-emitting element 150-1 may be deteriorated.

The applied solution 411 may be formed not only within the assembly hole 340H1 but also on the partition wall 340. In addition, the applied solution 411 may be filled into the recess 331 positioned at the bottom part of the assembly hole 340H1 through a space between the semiconductor light-emitting element 150-1 and the bottom part of the assembly hole 340H1.

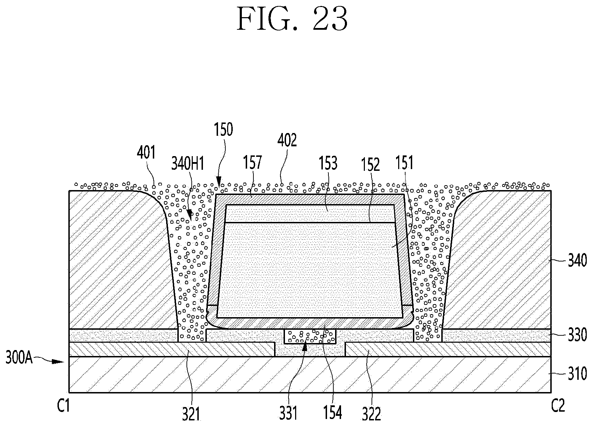

As illustrated in FIG. 23, a drying process may be performed so that the solvent 405 in the applied solution 411 may be evaporated, leaving behind the metal powder.

As illustrated in FIG. 24, a melting process may be performed so that the metal powder may be melted, thereby forming a metal film 450. The metal film 450 may be formed by each of the connection electrode 370-1 and the fixing member 380. The melting process may be a heat treatment process or a laser irradiation process, but is not limited thereto.

The connection electrode 370-1 may be formed on the partition wall 340 and the semiconductor light-emitting element 150-1. The connection electrode 370-1 may be formed around the semiconductor light-emitting element 150-1 within the assembly hole 340H1. The fixing member 380 may be formed in the recess 331.

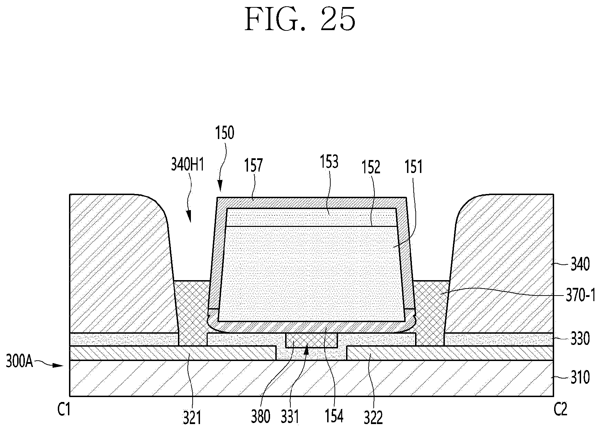

As illustrated in FIG. 25, an etching process may be performed to remove the connection electrode 370-1 on the partition wall 340 and the semiconductor light-emitting element 150-1, so that the connection electrode 370-1 may be disposed only within the assembly hole 340H1.

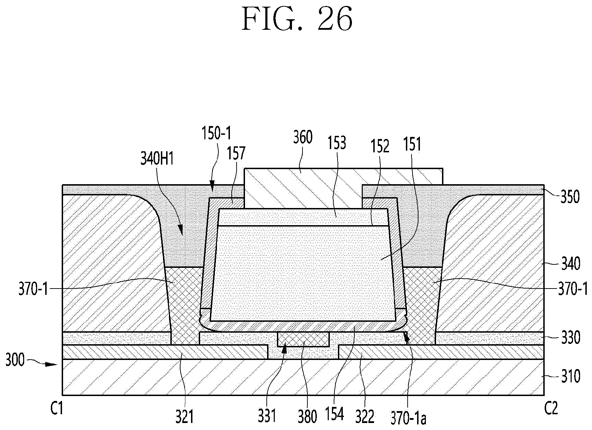

As illustrated in FIG. 26, a second insulating layer 350 may be formed on the substrate 310, and an electrode wiring 360 may be formed on the second insulating layer 350.

An insulating film may be deposited on the substrate 310 to form the second insulating layer 350. At this time, the thickness of the second insulating layer 350 may be increased, so that an upper surface of the second insulating layer 350 may have a flat, straight surface. The electrode wiring 360 may penetrate the second insulating layer 350 and be connected to an upper side of the semiconductor light-emitting element 150-1.

The display device 300 may be manufactured by the manufacturing process described above.

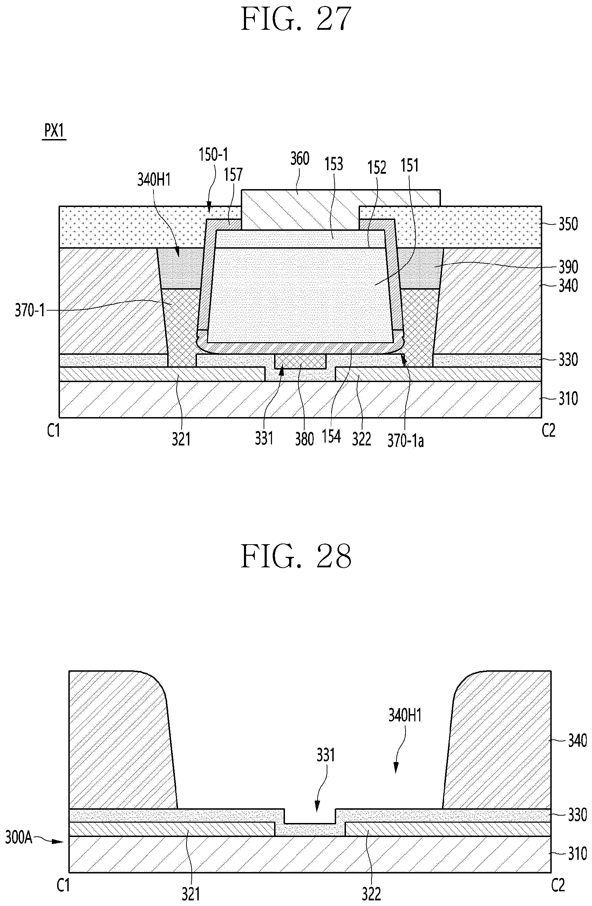

FIG. 27 is a cross-sectional view illustrating a first subpixel according to a second embodiment.

The second embodiment is similar to the first embodiment except for the third insulating layer 390. **In** the second embodiment, components having the same shape, structure, and/or function as those of the first embodiment are given the same drawing reference numerals and detailed descriptions are omitted.

Referring to FIG. 27, the first subpixel PX1 according to the second embodiment may comprise a substrate 310, a first assembly wiring 321, a second assembly wiring 322, a first insulating layer 330, a partition wall 340, a semiconductor light-emitting element 150-1, a fixing member 380, a third insulating layer 390, a connection electrode 370-1, a second insulating layer 350, and an electrode wiring 360.

The remaining components except for the third insulating layer 390, that is, the substrate 310, the first assembled wiring 321, the second assembled wiring 322, the first insulating layer 330, the partition wall 340, the semiconductor light-emitting element 150-1, the fixing member 380, the connection electrode 370-1, the second insulating layer 350, and the electrode wiring 360, have been described above, so that detailed descriptions are omitted.

**In** the second embodiment, the third insulating layer 390 may be formed simultaneously with the connection electrode 370-1 and the fixing member 380 by the same melting process.

As will be described later, a solvent, a metal powder, an additive, and an organic powder may be dispersed in the solution applied on the substrate 310. The solvent may be evaporated from the solution applied on the substrate 310 by a drying process. Thereafter, the metal powder may be melted by the melting process, and a metal film may be formed, so that the connection electrode 370-1 and the fixing member 380 may be formed. As the metal powder is formed as a metal film, the organic powder may be pushed upward and hardened, so that a third insulating layer 390 may be formed. Accordingly, the third insulating layer 390 may be formed of organic particles 413.

At this time, a plurality of blocks (380a of FIG. 35) or a plurality of bars (380b of FIG. 36) may be formed by not being pushed upward but remaining in the metal film. The plurality of blocks 380a may be fine lumps of organic powder, and the plurality of bars 380b may be formed by organic powder extending in one direction. Some of the plurality of bars 380b may be connected to the third insulating layer 390. **In** the drawing, the bar 380b has a straight shape along one direction, but it may have a curved shape or be broken in the middle.

Although not illustrated, the organic powder corresponding to the plurality of blocks 380a may be evaporated to form pores containing air.

Therefore, a material of the third insulating layer 390 and a material of the block 380a or the bar 380b may be the same.

The third insulating layer 390 may be disposed on the connection electrode 370-1. The third insulating layer 390 may be disposed along the perimeter of the semiconductor light-emitting element 150-1 within the assembly hole 340H1. An upper surface of the third insulating layer 390 may be the same as an upper surface of the partition wall 340, but is not limited thereto. **In** the drawing, a lower surface of the third insulating layer 390 is illustrated as having a flat straight surface, but may also have a curved, non-uniform surface, a round surface, or an uneven surface.

According to the second embodiment, the metal powder and the organic powder dispersed in the solution applied on the substrate 310 may be simultaneously formed by using a drying process and a melting process, thereby shortening the process time and simplifying the process. **In** addition, the semiconductor light-emitting element 150-1 may be more firmly fixed to the substrate 310 by the third insulating layer 390 as well as the fixing element 380, so that the fixing property of the semiconductor light-emitting element 150-1 can be strengthened. That is, since the semiconductor light-emitting element 150-1 is fixed to the first insulating layer 330 by the fixing member 380 and the semiconductor light-emitting element 150-1 is fixed to the partition wall 340 by the third insulating layer 390, the fixing property of the semiconductor light-emitting element 150-1 can be significantly strengthened, and thus product reliability can be improved.

Meanwhile, unlike the first embodiment, in the second embodiment, a height (or thickness) of the partition wall 340 may be smaller than a height (or thickness) of the semiconductor light-emitting element 150-1, but is not limited thereto.

The second insulating layer 350 may be disposed on the semiconductor light-emitting element 150-1 and the partition wall 340. The second insulating layer 350 may be disposed on the third insulating layer 390. Since the upper surface of the third insulating layer 390 is the same as the upper surface of the partition wall 340, it is easy to form the second insulating layer 350 having a flat straight surface with a thin thickness.

FIGS. 28 to 34 illustrate a manufacturing process of the first subpixel according to the second embodiment.

FIGS. 28 to 30 are the same as FIGS. 19 to 21 and have already been described above, so that detailed descriptions are omitted.

As illustrated in FIGS. 28 to 30, a backplane substrate 300A may be provided, and a semiconductor light-emitting element 150-1 may be assembled on the substrate 310 using a self-assembly process, and then an etching process may be performed so that the first assembled wiring 321 and/or the second assembled wiring 322 may be exposed, thereby removing the first insulating layer 330.

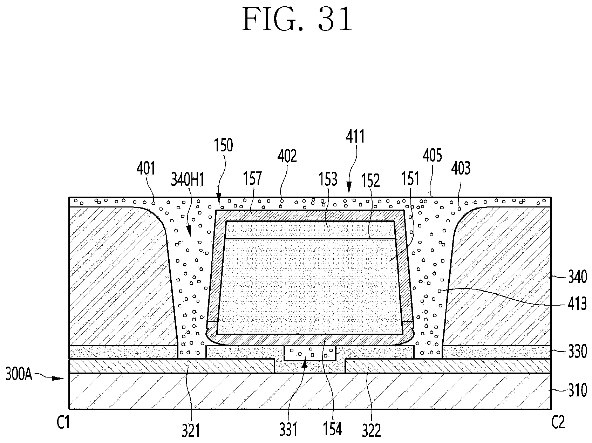

As illustrated in FIG. 31, a solution 411 in which metal powder, organic powder, solvent 405, and additives are dispersed may be applied onto a substrate 310. The metal powder may comprise electrode powder comprising electrode particles 401, magnetization powder comprising magnetization particles 402, and reflection powder comprising reflection particles 403. The organic powder may comprise organic particles 413.

The solution 411 may be applied onto the partition wall 340 and the semiconductor light-emitting element 150-1. The solution 411 may be filled around the semiconductor light-emitting element 150-1 in the assembly hole 340H1 and may also be filled in the recess 331 that is in contact with the assembly hole 340H1.

Thereafter, a drying process may be performed so that the solvent 405 may be evaporated.

As illustrated in FIG. 32, by performing a melting process, a connection electrode 370-1, a fixing member 380, and a third insulating layer 390 may be formed. The third insulating layer 390 may be formed on the connection electrode 370-1. The melting process may be a heat treatment process or a laser irradiation process, but is not limited thereto.

By the melting process, the metal powder in contact with the first assembly wiring 321 and/or the second assembly wiring 322 may be melted to form a metal film, and the metal film may be formed as the connection electrode 370-1. The metal powder on the partition wall 340 or the semiconductor light-emitting element 150-1 may be also melted and descend along the perimeter of the semiconductor light-emitting element 150-1, so that the thickness of the metal film may gradually increase, so that the connection electrode 370-1 having a desired thickness may be formed.

The target thickness of the metal film may have a height that horizontally overlaps a part of the passivation layer 157 of the semiconductor light-emitting element 150-1. To this end, the connection electrode 370-1 may electrically connect the first assembly wiring 321 and/or the second assembly wiring 322 and the electrode 154 of the semiconductor light-emitting element 150-1. The desired thickness of the metal film may be obtained by adjusting the amount or concentration of the metal powder dispersed in the solution 411.

The metal powder on the partition wall 340 or the semiconductor light-emitting element 150-1 may be utilized and descend along the perimeter of the semiconductor light-emitting element 150-1, thereby increasing the thickness of the metal film, and the organic powder positioned at a lower side of the assembly hole 340H1 may be pushed upward by the metal film, thereby increasing the thickness of the organic film 460. Accordingly, a metal film may be positioned at a lower side thereof along the perimeter of the semiconductor light-emitting element 150-1 in the assembly hole 340H1 to form a connection electrode 370-1, and an organic film 460 may be positioned on the metal film to form a third insulating layer 390. The organic film 460 may be formed as the third insulating layer 390 through a curing process, but is not limited thereto.

As another example, a plurality of blocks (380a in FIG. 35) or a plurality of bars (380b in FIG. 36) may be formed within the metal film, i.e., the connection electrode 370-1, by curing the organic powder without being pushed upward within the metal film. The organic powder of the block 380a or the bar 380b may be evaporated to form pores.

The metal powder filled in the recess 331 may be melted to form a metal film, and the metal film may be formed as a fixing member 380. The recess 331 may be filled with the metal film, so that an upper surface of the fixing member 380 may come into contact with a lower surface of the semiconductor light-emitting element 150-1. As another example, the metal film may fill a part of the lower side of the recess 331, and an organic film in which organic powder is hardened may be filled thereon, so that the fixing member 380 composed of the metal film and the organic film may be formed. As another example, the metal film may be filled in the recess 331, and a block 380a (or dot or pore) in which organic powder is hardened may be formed in the metal film, so that the fixing member 380 may be formed.

By adjusting the amount or concentration of the organic powder, the third insulating layer 390 may not be formed on the partition wall 340 or the semiconductor light-emitting element 150-1, but may be formed only on the assembly hole 340H1.

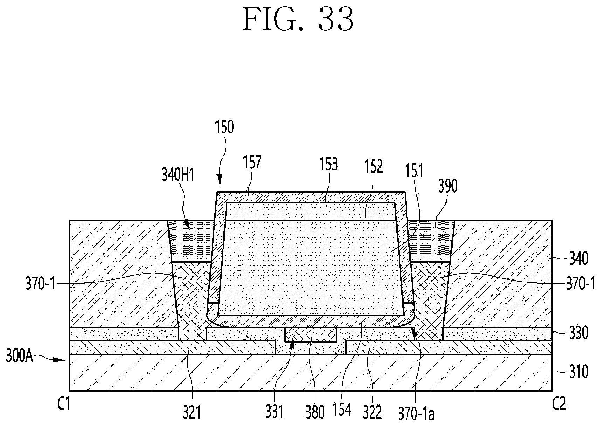

As illustrated in FIG. 33, by removing a part of the upper side of the partition wall 340 and a part of the upper side of the third insulating layer 390, the upper surface of the partition wall 340 and the upper surface of the third insulating layer 390 may be positioned on the same horizontal plane. This is to facilitate the flattening process of the second insulating layer 350, which is formed by a post-process and is to be used as a flattening layer, but the process may be omitted. By removing a part of the upper side of the partition wall 340 and a part of the upper side of the third insulating layer 390, the height (or thickness) of the partition wall 340 may be smaller than the height (or thickness) of the semiconductor light-emitting element 150-1.

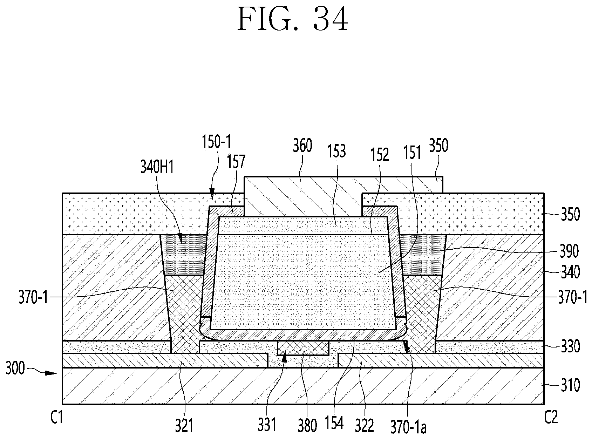

As illustrated in FIG. 34, a second insulating layer 350 may be formed by forming an organic film on the substrate 310. The second insulating layer 350 may be formed on the semiconductor light-emitting element 150-1 and the partition wall 340, and may be formed along the perimeter of the semiconductor light-emitting element 150-1 within the assembly hole 340H1.

Thereafter, a metal film may be formed and patterned on the substrate 310, so that the electrode wiring 360 may penetrate the second insulating layer 350 and be connected to the upper side of the semiconductor light-emitting element 150-1. Before forming the metal film, the passivation layer 157 on the upper side of the semiconductor light-emitting element 150-1 may be removed, so that the second conductivity type semiconductor layer 153 may be exposed.

FIG. 37 is a cross-sectional view illustrating a first subpixel according to a fifth embodiment.

The fifth embodiment is similar to the first embodiment except that the fixing member 380 is connected to the connection electrode 370-1. In the fifth embodiment, components having the same shape, structure, and/or function as those of the first embodiment are given the same drawing reference numerals, and detailed descriptions are omitted. The descriptions omitted in the fifth embodiment may be easily understood from the first embodiment.

Referring to FIG. 37, the first subpixel PX1 according to the fifth embodiment may comprise a substrate 310, a first assembly wiring 321, a second assembly wiring 322, a first insulating layer 330, a partition wall 340, a semiconductor light-emitting element 150-1, a fixing member 380, a connection electrode 370-1, a second insulating layer 350, and an electrode wiring 360.

In the fifth embodiment, the connection electrode 370-1 and the fixing member 380 may be formed simultaneously by the same melting process.

Unlike the first embodiment, in the fifth embodiment, the fixing member 380 may be connected to the connection electrode 370-1. The fixing member 380 may be connected to the connection electrode 370-1 at a lower side of the semiconductor light-emitting element 150-1. The fixing member 380 and the connection electrode 370-1 may be integrally formed at a lateral part and the lower side of the semiconductor light-emitting element 150-1 in the assembly hole 340H1.

The connection electrode 370-1 may be disposed not only around the perimeter of the semiconductor light-emitting element 150-1 but also at the lower side of the semiconductor light-emitting element 150-1, and may be connected to the fixing member 380 disposed in the recess 331.

When the semiconductor light-emitting element 150-1 may be assembled into the assembly hole 340H1 by a self-assembly process, the lower side of the semiconductor light-emitting element 150-1 may be spaced apart from the insulating layer 330. That is, the semiconductor light-emitting element 150-1 may be positioned on the insulating layer 330 at a predetermined distance without coming into contact with the insulating layer 330. Thereafter, when a solution in which metal powder, additives, etc. are dispersed in a solvent is applied onto the substrate 310, the solution may descend along the perimeter of the semiconductor light-emitting element 150-1 in the assembly hole 340H1 and flow between the lower side of the semiconductor light-emitting element 150-1 and the insulating layer 330 to fill the recess 331. Thereafter, a drying process and a melting process may be performed, so that the metal powder may be melted. Thus, the connection electrode 370-1 formed around the semiconductor light-emitting element 150-1 in the assembly hole 340H1 may be connected to the fixing member 380 formed in the recess 331 through the lower side of the semiconductor light-emitting element 150-1 and the insulating layer 330.

The thickness of the connection electrode 370-1 formed between the lower side of the semiconductor light-emitting element 150-1 and the insulating layer 330 may be smaller than the depth of the recess 331, but is not limited thereto.

The metal powder may comprise electrode powder comprising electrode particles 401, magnetization powder comprising magnetization particles 402, and reflective powder comprising reflective particles 403.

The connection electrode 370-1 and/or the fixing member 380 may comprise a reflective layer by the reflective particles 403 of the reflective powder. Since the connection electrode 370-1 and the fixing member 380 are disposed on the lateral part and the lower side of the semiconductor light-emitting element 150-1, the light generated from the semiconductor light-emitting element 150-1 may be reflected forward, thereby improving the light efficiency and luminance of the semiconductor light-emitting element 150-1.

Meanwhile, the fifth embodiment may be combined with the second to fourth embodiments.

Meanwhile, the display device described above may be a display panel. That is, in the embodiment, the display device and the display panel may be understood to have the same meaning. In the embodiment, the display device in the practical sense may comprise a display panel and a controller (or processor) that may control the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using a semiconductor light-emitting element. The semiconductor light-emitting element may be a micro-level semiconductor light-emitting element or a nano-level semiconductor light-emitting element.

For example, the embodiment may be adopted in a TV, signage, a mobile terminal such as a mobile phone or a smart phone, display for a computer such as laptops or desktop, a head-up display (HUD) for automobiles, a backlight unit for display, display for VR, AR or mixed reality (MR), a light source, etc.

## Claims

1. A display device, comprising:
a substrate;
a first assembly wiring and a second assembly wiring on the substrate;
an insulating layer having a recess on the first assembly wiring and the second assembly wiring;
a partition wall disposed on the first assembly wiring and the second assembly wiring and having an assembly hole that is in contact with the recess;
a semiconductor light-emitting element in the assembly hole;
a fixing member in the recess; and
a connection electrode between an outer side of the semiconductor light-emitting element and an inner side of the assembly hole,
wherein the fixing member and the connection electrode comprise an aggregate of lumps in which a plurality of conductive nanoparticles are entangled with each other.

2. The display device of claim 1, wherein the plurality of conductive nanoparticles comprise at least one or more particle of electrode particles, magnetization particles, and reflection particles.

3. The display device of claim 2, wherein a density of the magnetization particle is configured to increase as it moves away from an upper surface of the connection electrode in a downward direction.

4. The display device of claim 2, wherein adjacent electrode particles are entangled with each other through the magnetization particles.

5. The display device of claim 1, wherein a part of the connection electrode is configured to extend between the semiconductor light-emitting element and the insulating layer.

6. The display device of claim 1, wherein an upper surface of the connection electrode has a non-uniform surface.

7. The display device of claim 1, wherein an upper surface of the connection electrode has a round surface.

8. The display device of claim 1, comprising:
a second insulating layer on the partition wall, the semiconductor light-emitting element, and the connection electrode; and
an electrode wiring on the second insulating layer,
wherein the connection electrode is configured to connect a lateral part of the semiconductor light-emitting element to at least one or more of the first assembly wiring or the second assembly wiring, and
wherein the electrode wiring is configured to be connected to an upper part of the semiconductor light-emitting element.

9. The display device of claim 8, comprising:
a third insulating layer between the connection electrode and the second insulating layer in the assembly hole.

10. The display device of claim 9, wherein the connection electrode comprises a plurality of blocks, and a material of the blocks is the same as a material of the third insulating layer.

11. The display device of claim 9, wherein the connection electrode comprises a plurality of bars, and a material of the bars is the same as a material of the third insulating layer.

12. The display device of claim 11, wherein some of the plurality of bars are configured to be connected to the third insulating layer.

13. The display device of claim 9, wherein the connection electrode comprises a plurality of pores, and the pore comprise air.

14. The display device of claim 1, wherein the fixing member is disposed between the first assembly wiring and the second assembly wiring and between a lower surface of the semiconductor light-emitting element and an upper surface of the insulating layer.

15. The display device of claim 14, wherein the fixing member is configured to be connected to the connection electrode.

16. The display device of claim 14, wherein the connection electrode and the fixing member comprise reflective layers.

17. The display device of claim 1, wherein the connection electrode is disposed along a perimeter of the semiconductor light-emitting element in the assembly hole.

18. The display device of claim 1, wherein a gap between the outer side of the semiconductor light-emitting element and the inner side of the assembly hole is 1.5 micrometers or less.
